(19) Europäisches Patentamt
European Patent Office
Office européen des brevets

(11) EP 3 605 637 A1

(12) EUROPEAN PATENT APPLICATION
published in accordance with Art. 153(4) EPC

(43) Date of publication:
05.02.2020 Bulletin 2020/06

(21) Application number: 18776631.6

(22) Date of filing: 14.03.2018

(51) Int Cl.:
*H01L 51/50* (2006.01) *C08G 61/12* (2006.01)
*G02F 1/13357* (2006.01) *H01L 27/32* (2006.01)
*H05B 33/02* (2006.01)

(86) International application number:
PCT/JP2018/009887

(87) International publication number:
WO 2018/180485 (04.10.2018 Gazette 2018/40)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
KH MA MD TN

(30) Priority: 29.03.2017 JP 2017065665
29.03.2017 JP 2017065667
19.06.2017 JP 2017119632

(71) Applicant: Hitachi Chemical Company, Ltd.
Chiyoda-ku
Tokyo 100-6606 (JP)

(72) Inventors:
- KODAMA Shunsuke
Tokyo 100-6606 (JP)
- FUKUSHIMA Iori
Tokyo 100-6606 (JP)
- MORIYAMA Ryota
Tokyo 100-6606 (JP)
- SAKUMA Hirotaka
Tokyo 100-6606 (JP)
- ISHITSUKA Kenichi
Tokyo 100-6606 (JP)
- KAMO Kazuyuki
Tokyo 100-6606 (JP)
- SUGIOKA Tomotsugu
Tokyo 100-6606 (JP)
- YOSHINARI Yuki
Tokyo 100-6606 (JP)
- HONNA Ryo
Tokyo 100-6606 (JP)
- UCHIYAMA Tomomi
Tokyo 100-6606 (JP)
- ASANO Naoki
Tokyo 100-6606 (JP)
- TAKAIRA Hiroshi
Tokyo 100-6606 (JP)

(74) Representative: Beckmann, Claus
Kraus & Weisert
Patentanwälte PartGmbB
Thomas-Wimmer-Ring 15
80539 München (DE)

# (54) CHARGE TRANSPORT MATERIAL AND USE OF SAME

(57) A charge transport material containing at least one charge transport polymer selected from the group consisting of a first charge transport polymer having one or more monovalent conjugated diene-containing groups, and a second charge transport polymer having one or more monovalent dienophile-containing groups.

EP 3 605 637 A1

## Description

TECHNICAL FIELD

The present invention relates to a charge transport material and an ink composition that uses that material. Further, the present invention also relates to an organic layer that uses the charge transport material or the ink composition, and an organic electronic element, an organic electroluminescent element (also referred to as an "organic EL element"), a display element, an illumination device, and a display device that each include the organic layer.

BACKGROUND ART

Organic electronic elements are elements which use an organic substance to perform an electrical operation, and because they are expected to be capable of providing advantages such as low energy consumption, low prices and superior flexibility, they are attracting considerable attention as a potential alternative technology to conventional inorganic semiconductors containing mainly silicon. Examples of organic electronic elements include organic EL elements, organic photoelectric conversion elements, and organic transistors and the like.

Among organic electronic elements, organic EL elements are attracting attention for potential use in large-surface area solid state lighting source applications to replace incandescent lamps and gas-filled lamps and the like. Further, organic EL elements are also attracting attention as the leading self-luminous display for replacing liquid crystal displays (LCD) in the field of flat panel displays (FPD), and commercial products are becoming increasingly available.

Depending on the organic material used, organic EL elements can be broadly classified into two types: low-molecular weight type organic EL elements that use a low-molecular weight compound, and polymer type organic EL elements that use a polymer compound. Further, the production methods for organic EL elements are broadly classified into dry processes in which film formation is mainly performed in a vacuum system, and wet processes in which film formation is performed by plate-based printing such as relief printing or intaglio printing, or by plateless printing such as inkjet printing. Wet processes enable far simpler film formation than dry processes that require a vacuum system, and are therefore expected to be an indispensable method in the production of future large-screen organic EL displays. Accordingly, in recent years, the development of polymer compounds that are suited to wet processes that facilitate reductions in cost and increases in surface area is being actively pursued (for example, see Patent Document 1).

On the other hand, in the case of organic EL elements, further improvements in various element characteristics such as the emission efficiency would be desirable. In this regard, multilayering of organic layers in which the function of each layer is isolated is being tested as a technique for improving the performance of organic EL elements.

When multilayering is performed using wet processes, the lower layer requires solvent resistance relative to the solvent of the coating solution used when forming the upper layer. Accordingly, in order to facilitate multilayering, methods of enhancing the solvent resistance of the lower layer are being investigated.

For example, a method is known in which materials that exhibit opposing solubilities in water and organic solvents are selected as the materials for forming adjacent layers. Specifically, in one method, water-soluble PEDOT:PSS is used as the material for a buffer layer or hole injection layer, whereas a material that is soluble in organic solvents such as toluene is used as the material for a photoelectric conversion layer or light-emitting layer. By employing this method, the PEDOT:PSS layer is insoluble in the organic solvent such as toluene, and therefore a two-layer structure can be produced using a coating method.

Another method directed at multilayering is a method in which following film formation using a coating solution, a polymerization reaction is initiated by a form of stimulus such as heat or light, thereby making the organic layer insoluble (for example, Patent Document 2). Patent Document 2 discloses that by conducting a polymerization reaction of a material containing a polymer or oligomer having a polymerizable functional group such as an oxetane group and an ionic substituent such as a sulfonate group, insolubilization of an organic layer can be achieved.

PRIOR ART DOCUMENTS

PATENT DOCUMENTS

Patent Document 1: JP 2006-279007 A
Patent Document 2: JP 2013-181103 A

## SUMMARY OF THE INVENTION

### PROBLEMS TO BE SOLVED BY THE INVENTION

However, in the method that uses water-soluble PEDOT:PSS, moisture tends to be readily retained in the organic layer, which can sometimes cause a deterioration in the properties of the organic film. Further, the types of materials that can be used in multilayering are limited.

Further, in the above Patent Document 2, the polymer or oligomer having the aforementioned ionic substituent is synthesized in a form that contains a salt (potassium) of the ionic substituent. The potassium is removed by performing an ion exchange treatment following synthesis of the polymer or oligomer, but there is a possibility that some potassium may be retained in the polymer or oligomer. If an alkali metal such as potassium exists in the polymer or oligomer, then the performance of the element tends to deteriorate.

Moreover, in those cases where a curing is used to insolubilize an organic layer, a material containing a polymerizable polymer or oligomer, a polymerization initiator and a solvent is typically used. Following application of the material, the insolubilization can be achieved, for example, by heating. When a material containing a polymerization initiator is used in this manner, for example to form a hole transport layer or hole injection layer adjacent to a light-emitting layer, the polymerization initiator can sometimes migrate into the light-emitting layer, impairing the function of the light-emitting layer. Furthermore, if the heating temperature used when curing the organic layer is too high, then problems in the lower layer such as a deterioration in the performance are more likely to occur.

As a result of the above issues, in order to achieve improvements in the performance of an organic EL element by performing multilayering using a wet process, the development of a material that enables simple multilayering by a wet process without impairing the properties of adjacent layers would be very desirable.

Accordingly, the present invention has been developed in light of the above circumstances, and has the objects of providing a charge transport material containing a polymer that does not contain a polymerization initiator and can be insolubilized at low temperature, and providing an ink composition containing that charge transport material. Further, the present invention also has the objects of providing an organic layer that has been insolubilized at low temperature using the above charge transport material or ink composition, and providing an organic electronic element, an organic EL element, a display element, an illumination device and a display device which each include the organic layer.

### MEANS TO SOLVE THE PROBLEMS

As a result of intensive investigation of the insolubilization of charge transport polymers, the inventors of the present invention discovered that by using a charge transport polymer having a structure including a conjugated diene-containing group and/or a dienophile-containing group as a polymerizable functional group, the polymer could be insolubilized at a lower temperature than conventional polymers without using a polymerization initiator, and they were therefore able to complete the present invention. Embodiments of the present invention relate to aspects described below, but the invention in not limited to these embodiments.

One embodiment relates to a charge transport material containing at least one charge transport polymer selected from the group consisting of a first charge transport polymer having one or more monovalent conjugated diene-containing groups, and a second charge transport polymer having one or more monovalent dienophile-containing groups.

In the charge transport material described above, the first charge transport polymer and the second charge transport polymer preferably each have a structure that is branched in three or more directions.

In the charge transport material described above, the first charge transport polymer and the second charge transport polymer preferably each have one or more structures selected from the group consisting of substituted or unsubstituted aromatic amine structures, carbazole structures, thiophene structures, benzene structures and fluorene structures.

The charge transport material described above preferably has hole injection properties or hole transport properties.

In the charge transport material described above, it is preferable that at least one monovalent conjugated diene-containing group exists at a terminal of the first charge transport polymer, and at least one dienophile-containing group exists at a terminal of the second charge transport polymer.

In the charge transport material described above, the monovalent conjugated diene-containing group is preferably a monovalent furan ring-containing group having a structure represented by formula (I) shown below.

[Chemical formula 1]

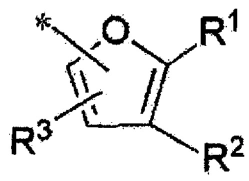

(I)

[In the formula, each of $R^1$ to $R^3$ independently represents a group selected from the group consisting of -H, - $C_nH_{2n+1}$ (wherein n is an integer of 1 to 6), -C(=O)H, $-CH_2OH$, -Br and -Cl. Further, "*" denotes a bonding site with another structural region.

In the charge transport material described above, the monovalent dienophile-containing group is preferably a monovalent maleimide ring-containing group having a structure represented by formula (II-1) shown below.

[Chemical formula 2]

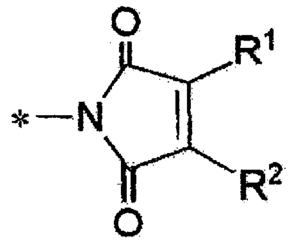

(II-1)

[In the formula, each of $R^1$ and $R^2$ independently represents a group selected from the group consisting of **-H** and $-C_nH_{2n+1}$ (wherein n is an integer of 1 to 6). $R^1$ and $R^2$ may be linked together to form a ring. The symbol "*" denotes a bonding site with another structural region.]

In one embodiment, the charge transport material described above preferably contains a first charge transport polymer or second charge transport polymer described above, and more preferably contains a first charge transport polymer.

In another embodiment, the charge transport material described above preferably contains a first charge transport polymer and a second charge transport polymer.

In yet another embodiment, in those cases where the charge transport material described above contains a first charge transport polymer and a second charge transport polymer, the monovalent dienophile-containing group preferably has a styrene structure represented by formula (III) shown below.

[Chemical formula 3]

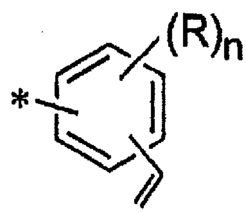

(III)

[In the formula, each R independently represents an alkyl group of 1 to 6 carbon atoms. Further, n represents an integer of 0 to 4, and * denotes a bonding site with another structural region.]

Another embodiment relates to an ink composition containing the charge transport material of an embodiment described above and a solvent.

Another embodiment of the present invention relates to an organic electronic element having an organic layer formed using the charge transport material of an embodiment described above or the ink composition of the embodiment described above.

Another embodiment relates to an organic electroluminescent element having an organic layer formed using the charge transport material of an embodiment described above or the ink composition of the embodiment described above.

The above organic electroluminescent element preferably also has a flexible substrate. Further, the flexible substrate preferably includes a resin film.

Another embodiment relates to a display element containing the organic electroluminescent element described above.

Another embodiment relates to an illumination device containing the organic electroluminescent element described above.

Another embodiment relates to a display device containing the illumination device described above, and a liquid crystal element as a display unit.

The disclosure of the present application is related to the subject matter disclosed in prior Japanese Applications 2017-065665 and 2017-065667 filed on March 29, 2017, and prior Japanese Application 2017-119632 filed on June 19, 2017; the entire contents of which are incorporated by reference herein.

## EFFECTS OF THE INVENTION

The present invention is able to provide a charge transport material that is suitable for wet processes and can be insolubilized at low temperature without using a polymerization initiator, and an ink composition that contains that material. Further, the present invention can also provide an organic layer containing no polymerization initiator that has been insolubilized at low temperature using the above charge transport material or ink composition, and an organic electronic element, an organic EL element, a display element, an illumination device and a display device which each include the organic layer.

## BRIEF DESCRIPTION OF THE DRAWINGS

FIG. 1 is a cross-sectional schematic view illustrating one embodiment of an organic EL element.

## EMBODIMENTS FOR CARRYING OUT THE INVENTION

Embodiments of the present invention are described below in further detail. However, the present invention is not limited to these embodiments, and includes a large variety of embodiments.

### <Charge Transport Material>

The charge transport material contains at least one type of charge transport polymer that has the ability to transport an electric charge and has a specific polymerizable functional group described below. In one embodiment, the charge transport material may include at least two types of charge transport polymer which each have the ability to transport an electric charge and which are capable of reacting together. In a more specific embodiment, the charge transport material may contain at least one charge transport polymer selected from the group consisting of a first charge transport polymer having one or more monovalent conjugated diene-containing groups, and a second charge transport polymer having one or more monovalent dienophile-containing groups.

In the present description, the term "polymer" is deemed to include the term "oligomer" which describes polymers having a low degree of polymerization. Further, in the present description, the terms "conjugated diene-containing group" and "dienophile-containing group" are used, but these terms do not necessarily imply the use of a combination of the first and second charge transport polymers. As described below, the charge transport material is not limited to embodiments that use a combination of the first and second charge transport polymers, and may be an embodiment that uses only one of either the first or second charge transport polymer.

From the viewpoint of changing the degree of solubility in solvents as a result of the polymerization reaction, the charge transport polymer preferably has at least one polymerizable functional group within the molecule. A "polymerizable functional group" means a functional group capable of forming bonds upon application of at least one of heat and light.

Conventional polymerizable charge transport polymers typically have a polymerizable functional group such

as an oxetane group or epoxy group. In order to satisfactorily insolubilize (cure) such polymers, a polymerization initiator must be used, and heating must be performed, for example, at a high temperature of 230°C. In contrast, the inventors of the present invention discovered that when a charge transport polymer having a conjugated diene-containing group and/or a dienophile-containing group (also referred to as an olefin-containing group) as a polymerizable functional group is used, insolubilization can be achieved at a lower temperature than conventional polymers, without using a polymerization initiator.

Polymerization of a compound having an oxetane group or epoxy group proceeds by an active species generated from the polymerization initiator upon heating, or a ring-opened oxetane group or epoxy group generated by this active species, attacking and undergoing addition to an oxetane group or epoxy group having an unopened ring. In contrast, a conjugated diene-containing group or dienophile-containing group adopts a different mechanism from the polymerization of the above compound having an oxetane group or epoxy group. Namely, although not bound by theory, it is thought that a compound having a conjugated diene-containing group or a dienophile-containing group undergoes polymerization as a result of an addition reaction at the double bond, meaning the polymer insolubilization can be achieved at a lower temperature than conventional polymers.

Accordingly, in one embodiment, the charge transport polymer preferably contains at least one of a conjugated diene-containing group and a dienophile-containing group within the molecule, and from the viewpoint of reactivity, preferably contains one of either a conjugated diene-containing group or a dienophile-containing group. More specifically, in one embodiment, the charge transport material preferably contains either a charge transport polymer having a conjugated diene-containing group or a charge transport polymer having a dienophile-containing group, and more preferably contains a charge transport polymer having a conjugated diene-containing group.

Further, compounds having a conjugated diene-containing group and a dienophile-containing group can function as a reactant for cycloaddition reactions such as the Diels-Alder reaction. As a result, if a conjugated diene-containing group and a dienophile-containing group coexist within the charge transport material, and heating is performed with both of these groups present within the same film, then cycloaddition reactions are possible. The cycloaddition reaction arising from a Diels-Alder reaction between a conjugated diene-containing group and a dienophile-containing group tends to proceed at an even lower temperature than the addition polymerization reaction of the compound having the conjugated diene-containing group or dienophile-containing group.

For these reasons, in one embodiment, a combination of a charge transport polymer having a monovalent conjugated diene-containing group and a charge transport polymer having a monovalent dienophile-containing group is preferably used. It is thought that by employing this embodiment using a combination of these two types of polymers, insolubilization (curing) of the organic layer can be achieved at lower temperatures than have conventionally been possible.

In the charge transport material of the embodiment described above, there are no particular limitations on the blend ratio between the first charge transport polymer having a monovalent conjugated diene-containing group and the second charge transport polymer having a monovalent dienophile-containing group, and the ratio is preferably adjusted with due consideration of the molar ratio between the conjugated diene-containing group and the dienophile-containing group. In one embodiment, from the viewpoint of enabling a Diels-Alder reaction to proceed efficiently, a ratio (molar ratio) of conjugated diene-containing group / dienophile-containing group, is preferably within a range from 0.05 to 20, more preferably within a range from 0.1 to 10, and even more preferably within a range from 0.25 to 4.

The charge transport polymer is described below in detail. The following description uses the term "first charge transport polymer and second charge transport polymer", but as mentioned above, the charge transport material is not limited to embodiments that use a combination of the first and second charge transport polymers, and also includes embodiments that use only one of the first and second charge transport polymers.

[Charge Transport Polymer]

(Monovalent Conjugated Diene-Containing Group)

The monovalent conjugated diene-containing group in the first charge transport polymer means a group which, for example, has a structure derived from a conjugated diene compound that can generally be used in a Diels-Alder reaction. There are no particular limitations on the conjugated diene compound, provided it is a compound containing two conjugated double bonds. The conjugated diene compound may be a chain-like compound or a cyclic compound.

The conjugated diene compound may be a compound in which a substituent such as an alkyl group has been introduced into the conjugated diene skeleton. The alkyl group ($-C_nH_{2n+1}$) may have a carbon number n of 1 to 6, and may have a linear, branched or cyclic structure. The conjugated diene compound preferably has a high electron density for the conjugated diene portion.

The conjugated diene-containing group may have a structure derived from a furan ring, thiophene ring, pyrrole ring, cyclopentadiene ring, 1,3-butadiene, thiophene-1-oxide ring, thiophene-1,1-dioxide ring, cyclopenta-2,4-dienone

ring, 2H pyran ring, cyclohexa-1,3-diene ring, 2H pyran-1-oxide ring, 1,2-dihydropyridine ring, 2H thiopyran-1,1-dioxide ring, cyclohexa-2,4-dienone ring, pyran-2-one ring or anthracene, and may also have a substituent on one of these structures.

From the viewpoint of the reactivity, the conjugated diene-containing group preferably has a structure derived from a furan ring, cyclopentadiene ring, 1,3-butadiene, thiophene-1,1-dioxide ring or anthracene.

The aforementioned monovalent conjugated diene-containing group more preferably has a structure derived from a furan ring, cyclopentadiene ring or anthracene, and even more preferably has a structure derived from a furan ring.

(Monovalent Furan Ring-Containing Group)

In one embodiment, the monovalent conjugated diene-containing group is preferably a monovalent furan ring-containing group having a structure represented by formula (I) shown below.

[Chemical formula 4]

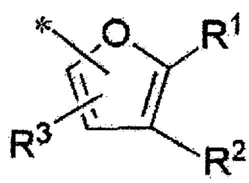

(I)

In the formula, each of $R^1$ to $R^3$ independently represents a group selected from the group consisting of -H, $-C_nH_{2n+1}$ (wherein n is an integer of 1 to 6), -C(=O)H, $-CH_2OH$, -Br and -Cl. The symbol "*" denotes a bonding site with another structural region.

In one embodiment, the monovalent furan ring-containing group is preferably a group having a structure represented by the above formula (I) in which each of $R^1$ to $R^3$ independently represents -H or - $C_nH_{2n+1}$ (wherein n is an integer of 1 to 6). In another embodiment, the monovalent conjugated diene-containing group is preferably a group having a structure represented by the above formula (I) in which R1 is a group selected from the group consisting of -C(=O)H, $-CH_2OH$, -Br and -Cl, and each of $R^2$ and $R^3$ independently represents -H or $-C_nH_{2n+1}$ (wherein n is an integer of 1 to 6).

The monovalent furan ring-containing group more preferably has a structure represented by formula (I-1) shown below.

[Chemical formula 5]

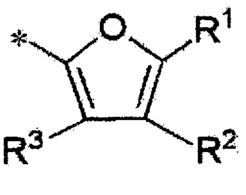

(I-1)

In the formula, $R^1$ to $R^3$ and "*" are the same as described above. In one embodiment, the monovalent furan ring-containing group more preferably has a structure represented by the above formula (I-1) in which $R^1$ represents -H or -C(=O)H, and each of $R^2$ and $R^3$ represents -H. In the above embodiment, it is even more preferable that each of $R^1$ to $R^3$ represents -H.

The monovalent furan ring-containing group may have a structure containing two bonded furan rings, as represented by in formula (I-2) shown below. In the formula, each of $R^1$ to $R^5$ independently represents a group selected from the group consisting of -H, $-C_nH_{2n+1}$ (wherein n is an integer of 1 to 6), - C(=O)H, $-CH_2OH$, -Br and -Cl. The symbol "*" denotes a bonding site with another structural region. Moreover, X represents a divalent linking group selected from the group consisting of linear, branched and cyclic alkylene groups of 1 to 6 carbon atoms.

[Chemical formula 6]

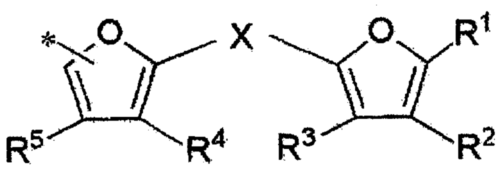

(I-2)

One embodiment more preferably has a structure represented by the above formula (I-2) in which $R^1$ represents a group selected from the group consisting of -H, $-C_nH_{2n+1}$ (wherein n is an integer of 1 to 6) and - C(=O)H, each of $R^2$ to $R^5$ represents either -H or $-C_nH_{2n+1}$ (wherein n is an integer of 1 to 6), and X represents a linear alkylene group of 1 to 3 carbon atoms. In this embodiment, it is even more preferable that each of $R^1$ to $R^5$ represents -H, and X is a methylene group.

In one embodiment, the charge transport material preferably contains a charge transport polymer having the furan ring-containing group described above. A charge transport polymer having the aforementioned furan ring-containing group tends to be able to be readily insolubilized by a homopolymerization of the polymer. Further, a charge transport polymer having the furan ring-containing group tends to readily undergo a Diels-Alder reaction when used in combination with a charge transport polymer having a dienophile-containing group described below. In this case, insolubilization of the polymer tends to be achievable at even lower temperatures than homopolymerization.

(Monovalent Dienophile-Containing Group)

The monovalent dienophile-containing group in the second charge transport polymer means a group having a structure derived from a dienophile compound that can generally be used in a Diels-Alder reaction. In other words, there are no particular limitations on the monovalent dienophile-containing group, provided it is derived from an olefin group-containing compound having a double bond or triple bond (namely a dienophile compound). The dienophile compound may be a chain-like compound or a cyclic compound.

The dienophile compound preferably has a double bond, and may also have an introduced substituent such as an alkyl group. The alkyl group ($-C_nH_{2n+1}$) may have a carbon number n of 1 to 6, and may have a linear, branched or cyclic structure. The dienophile compound preferably has a low electron density for the double bond portion.

The monovalent dienophile-containing group may have a structure derived from maleic anhydride, maleic acid, a maleic acid monoester, a maleic acid diester, a maleimide, fumaric acid, itaconic acid, acrolein, acrylic acid, methacrylic acid, acryloyl chloride, methacryloyl chloride, an acrylate ester, a methacrylate ester, 1,4-benzoquinone, 1,4-naphthoquinone, a 2,5-dihydrofuran, or a pyrroline or the like. These groups may have a substituent on the double bond or in a portion adjacent to the double bond.

In one embodiment, the monovalent dienophile-containing group may have a structure represented by formula (II) shown below. In the formula, each of $R^1$ to $R^6$ independently represents a group selected from the group consisting of -H and $-C_nH_{2n+1}$ (wherein n is an integer of 1 to 6). Further, $R^3$ and $R^4$ may be linked together to form a ring. The symbol "*" denotes a bonding site with another structural region.

[Chemical formula 7]

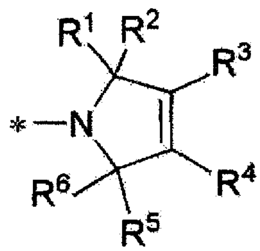

(II)

In one embodiment, form the viewpoint of the reactivity, the monovalent dienophile-containing group preferably has a structure derived from a compound in which a carbonyl carbon is bonded to a portion adjacent to the double bond. For example, the dienophile-containing group preferably has a structure derived from maleic anhydride, a maleic acid ester or a maleimide, and more preferably has a structure derived from a maleimide.

(Monovalent Maleimide Ring-Containing Group)

In one embodiment, the monovalent dienophile-containing group is preferably a monovalent maleimide ring-containing group having a structure represented by formula (II-1) shown below.

[Chemical formula 8]

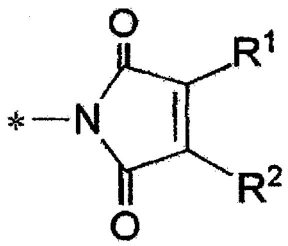

(II-1)

In the formula, each of $R^1$ and $R^2$ independently represents a group selected from the group consisting of -H and $-C_nH_{2n+1}$ (wherein n is an integer of 1 to 6). $R^1$ and $R^2$ may be linked together to form a ring. The symbol "*" denotes a bonding site with another structural region. It is preferable that each of $R^1$ and $R^2$ represents -H.

In another embodiment, the dienophile-containing group may be a monovalent group having at least a styrene structure represented by formula (III) shown below.

[Chemical formula 9]

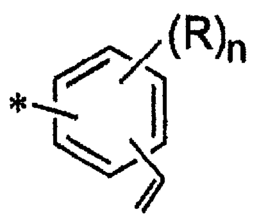

(III)

In the formula, each R independently represents a substituent, and for example, may be an alkyl group of 1 to 6 carbon atoms. The alkyl group may have a linear, branched or cyclic structure. Adjacent R groups may be linked together to form a ring. Further, n represents an integer of 0 to 4. A value of 0 for n means the styrene structure is unsubstituted. The symbol "*" denotes a bonding site with another structural region.

In one embodiment, the dienophile-containing group may be a group such as that represented by formula (IIIA) shown below, in which a styrene structure has been introduced as a substituent into any of various compounds (excluding styrene) containing a double bond capable of reacting with a conjugated diene compound.

[Chemical formula 10]

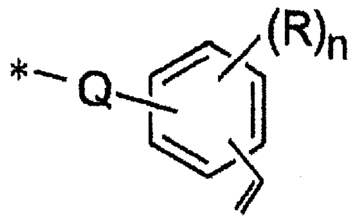

(IIIA)

In the formula, Q represents a divalent group derived from any of various compounds (excluding styrene) containing a double bond capable of reacting with a conjugated diene compound. The styrene structure may be introduced within the double bond portion or adjacent to the double bond in the compound. In the above formula, R and n are as described above.

In the above formula, examples of Q include groups derived from the aforementioned maleic anhydride, maleic acid, a maleic acid monoester, a maleic acid diester, a maleimide, fumaric acid, itaconic acid, acrolein, acrylic acid, methacrylic acid, acryloyl chloride, methacryloyl chloride, an acrylate ester, a methacrylate ester, 1,4-benzoquinone, 1,4-naphthoquinone, or a 2,5-dihydrofuran or the like.

In yet another embodiment, the dienophile-containing group may be a group in which a styrene structure has been introduced as a substituent into a compound having a simple vinyl group or allyl group, but containing no hetero atoms such as nitrogen, oxygen or sulfur atoms.

Among the embodiments of the aforementioned monovalent group having a styrene structure, in terms of facilitating polymer synthesis using a Suzuki-Miyaura coupling reaction, the monovalent dienophile-containing group is more preferably composed only of a styrene structure represented by the above formula (III). In other words, the monovalent dienophile-containing group is more preferably a monovalent styrene group represented by the above formula (III).

For these types of reasons, in one embodiment, the monovalent dienophile-containing group is even more preferably an unsubstituted monovalent styrene group represented by formula (III-1) shown below. In the formula, * denotes a bonding site with another structural region.

[Chemical formula 11]

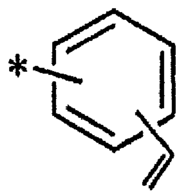

(III-1)

In the above embodiment, the position of the vinyl group in the styrene structure may be any one of an ortho position, meta position or para position relative to the bonding site with another structural region, but as shown in the formulas below, the meta position or para position is more preferred.

[Chemical formula 12]

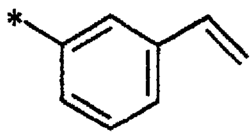

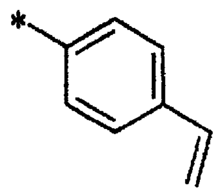

From the viewpoints of increasing the degree of freedom associated with the monovalent conjugated diene-containing group and the monovalent dienophile-containing group described above (hereafter each referred to as a

"polymerizable functional group") and facilitating the polymerization reaction (the homopolymerization or Diels-Alder reaction), the main skeleton of the charge transport polymer and the polymerizable functional group are preferably linked, for example, via a linear alkylene chain of 1 to 8 carbon atoms, although the invention is not limited to such structures.

Furthermore, in the case where, for example, the organic layer is to be formed on an electrode, from the viewpoint of enhancing the affinity with hydrophilic electrodes of ITO or the like, the main skeleton and the polymerizable functional group are preferably linked via a hydrophilic chain such as an ethylene glycol chain or a diethylene glycol chain. Moreover, from the viewpoint of simplifying preparation of the monomer used for introducing the polymerizable functional group, the charge transport polymer may have an ether linkage or an ester linkage at the terminal portion of the alkylene chain and/or the hydrophilic chain, namely, at the linkage site between these chains and the polymerizable functional group, and/or at the linkage site between these chains and the skeleton of the charge transport polymer.

From the viewpoint of contributing to a change in the degree of solubility, the polymerizable functional group is preferably included in a large amount within the charge transport polymer. On the other hand, from the viewpoint of not impeding the charge transport properties, the amount included in the charge transport polymer is preferably kept small. The amount of the polymerizable functional group may be set as appropriate with due consideration of these factors.

For example, from the viewpoint of obtaining a satisfactory change in the degree of solubility, the number of polymerizable functional groups per molecule of the charge transport polymer is preferably at least 2, and more preferably 3 or greater. Further, from the viewpoint of maintaining favorable charge transport properties, the number of polymerizable functional groups is preferably not more than 1,000, and more preferably 500 or fewer.

The number of polymerizable functional groups per molecule of the charge transport polymer can be determined as an average value, using the amount of the polymerizable functional group used in synthesizing the charge transport polymer (for example, the amount added of the monomer having the polymerizable functional group), the amounts added of the monomers corresponding with the various structural units, and the weight average molecular weight of the charge transport polymer and the like. Further, the number of polymerizable functional groups can also be calculated as an average value using the ratio between the integral of the signal attributable to the polymerizable functional group and the integral of the total spectrum in the $^1$H-NMR (nuclear magnetic resonance) spectrum of the charge transport polymer, and the weight average molecular weight of the charge transport polymer and the like. In terms of simplicity, if the amounts added of the various components are clear, then the value determined using these amounts is preferably employed.

(Structure of Charge Transport Polymer)

The expression "charge transport polymer" used in the following description means both the first charge transport polymer having a monovalent conjugated diene-containing group and the second charge transport polymer having a monovalent dienophile-containing group.

The charge transport polymer may be linear, or may have a branched structure. The charge transport polymer preferably contains at least a divalent structural unit L having charge transport properties and a monovalent structural unit T that constitutes the terminal portions, and may also contain a trivalent or higher valent structural unit B that forms a branched portion. The charge transport polymer may have only one type of each of these structural units, or may contain a plurality of types of each structural unit. In the charge transport polymer, the various structural units are bonded together at "monovalent" to "trivalent or higher valent" bonding sites.

In one embodiment, the charge transport polymer contains a trivalent or higher valent structural unit B that constitutes a branched portion that is "branched in three or more directions". Here, the expression "trivalent or higher valent" used in relation to a structural unit means that three or more dangling bonds that form bonding sites with other structural units exist within the structural unit. In other words, the valency of the structural unit corresponds with the number of those dangling bonds.

In one embodiment, the charge transport polymer contains a trivalent or higher valent structural unit B that constitutes a branched portion, and also contains at least a monovalent structural unit T that forms the terminal portions. In another embodiment, the charge transport polymer contains a trivalent or higher valent structural unit B, and also contains a divalent structural unit L having charge transport properties and a monovalent structural unit T. From the viewpoint of the charge transport properties, the latter embodiment is preferred.

Examples of partial structures contained in the charge transport polymer are described below. However, the charge transport polymer is not limited to polymers having the following partial structures. In the partial structures, "B" represents a structural unit B, "L" represents a structural unit L, and "T" represents a structural unit T. The symbol "*" denotes a bonding site with another structural unit. In the following partial structures, the plurality of B units may be units having the same structure or units having mutually different structures. This also applies for the T and L units.

Example of Linear Charge Transport Polymer

[Chemical formula 13] T-L-L-L-L-L-*

Examples of Charge Transport Polymers having Branched Structures

[Chemical formula 14]

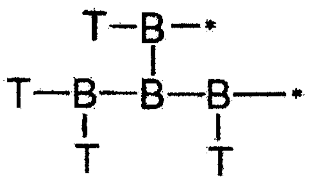

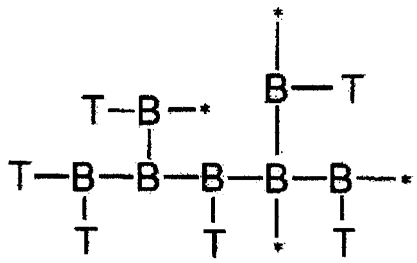

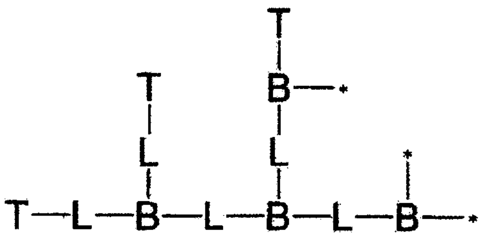

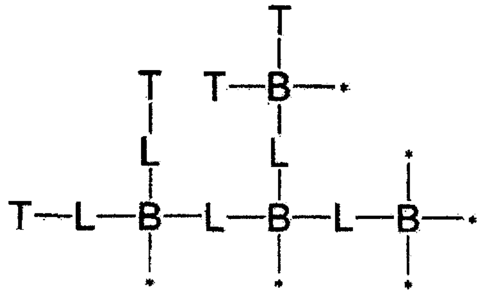

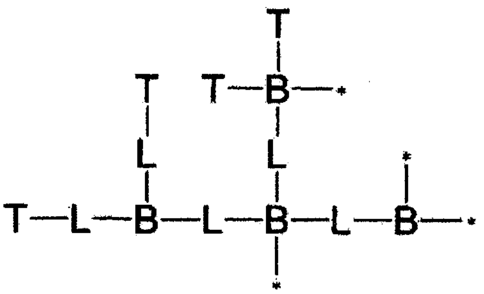

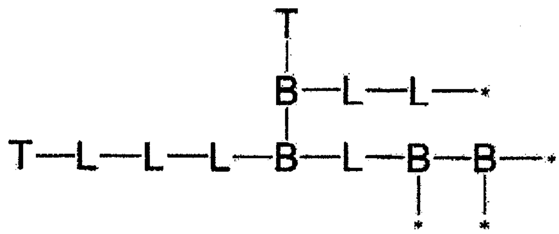

In the charge transport polymer, the polymerizable functional group (the monovalent conjugated diene-containing group or the monovalent dienophile-containing group) may be introduced at a terminal portion of the charge transport polymer (namely, a structural unit T), at a portion other than a terminal portion (namely, a structural unit L or B), or at both a terminal portion and a portion other than a terminal. From the viewpoint of the curability, the polymerizable functional group is preferably introduced at least at a terminal portion, and from the viewpoint of achieving a combination of favorable curability and charge transport properties, is preferably introduced only at terminal portions.

Further, in those cases where the charge transport polymer has a branched structure, the polymerizable functional group may be introduced within the main chain of the charge transport polymer, within a side chain, or within both the main chain and a side chain. In one embodiment, from the viewpoint of the reactivity between charge transport polymer molecules, at least one of the first and second charge transport polymers preferably has at least one polymerizable functional group at a terminal. Each of the structural units is describe below in further detail.

(Structural Unit L)

The structural unit L is a divalent structural unit having charge transport properties. There are no particular limitations on the structural unit L, provided it includes an atom grouping having the ability to transport an electric charge. For example, the structural unit L may be selected from among substituted or unsubstituted structures including aromatic amine structures, carbazole structures, thiophene structures, bithiophene structures, fluorene structures, benzene structures, biphenyl structures, terphenyl structures, naphthalene structures, anthracene structures, tetracene structures, phenanthrene structures, dihydrophenanthrene structures, pyridine structures, pyrazine structures, quinoline structures, isoquinoline structures, quinoxaline structures, acridine structures, diazaphenanthrene structures, furan structures, pyrrole structures, oxazole structures, oxadiazole structures, thiazole structures, thiadiazole structures, triazole structures, benzothiophene structures, benzoxazole structures, benzoxadiazole structures, benzothiazole structures, benzothiadiazole structures, benzotriazole structures, and structures containing one, or two or more, of the above structures. Among the aromatic amine structures, triarylamine structures are preferred, and triphenylamine structures are more preferred. Further, among the benzene structures, p-phenylene and m-phenylene structures are preferred.
In one embodiment, from the viewpoint of obtaining superior hole transport properties, the structural unit L is preferably selected from among substituted or unsubstituted structures including aromatic amine structures, carbazole structures, thiophene structures, bithiophene structures, fluorene structures, benzene structures, pyrrole structures, and structures containing one, or two or more, of these structures, and is more preferably selected from among substituted or unsubstituted structures including aromatic amine structures, carbazole structures, and structures containing one, or two or more, of these structures.
In another embodiment, from the viewpoint of obtaining superior electron transport properties, the structural unit L is preferably selected from among substituted or unsubstituted structures including fluorene structures, benzene structures, phenanthrene structures, pyridine structures, quinoline structures, and structures containing one, or two or more, of these structures.
Specific examples of the structural unit L are shown below. However, the structural unit L is not limited to the following structures.

[Chemical formula 15]

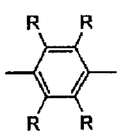
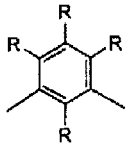
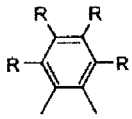
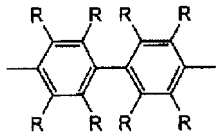
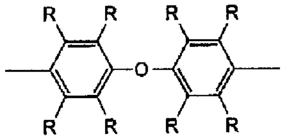
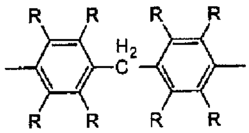
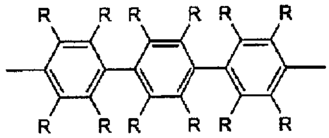
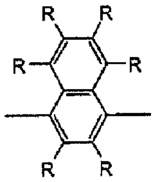
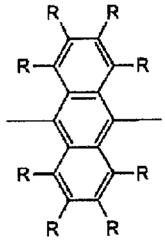
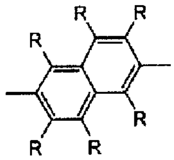
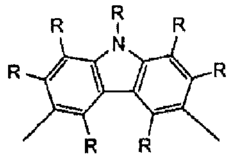
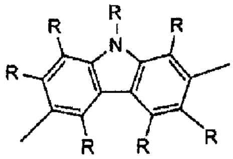
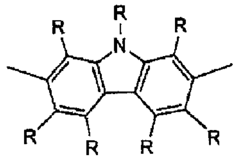
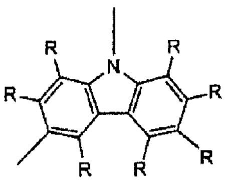
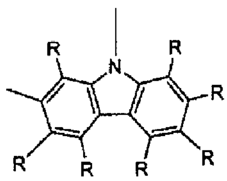
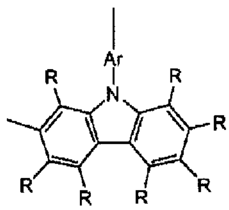
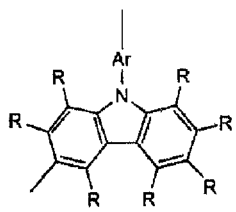
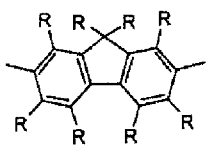
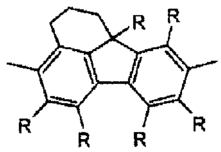
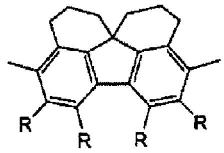
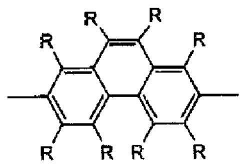
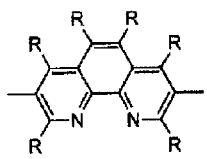
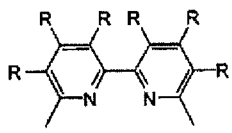
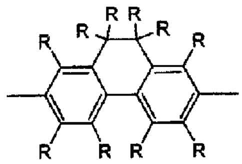
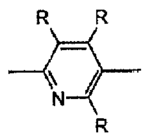
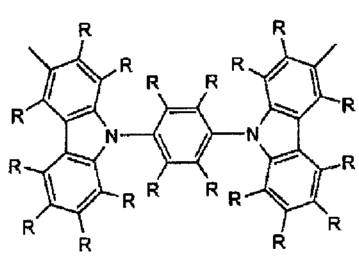
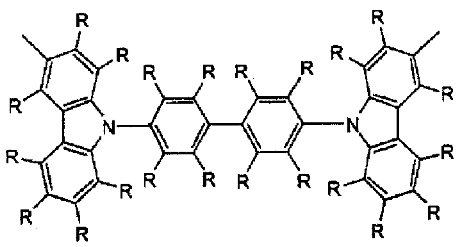

[Chemical formula 16]

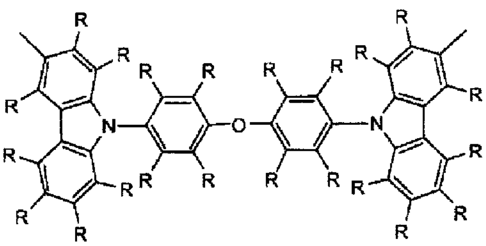
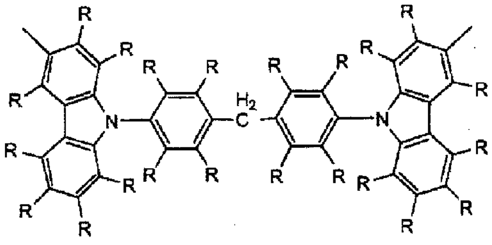
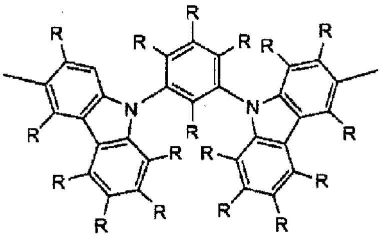
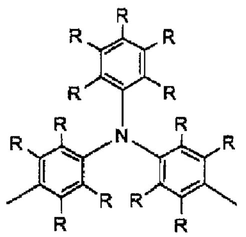
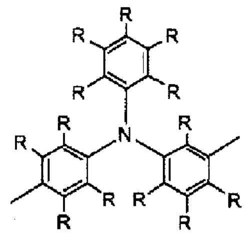
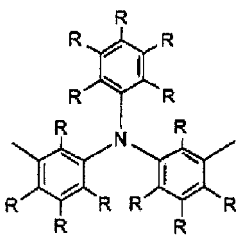
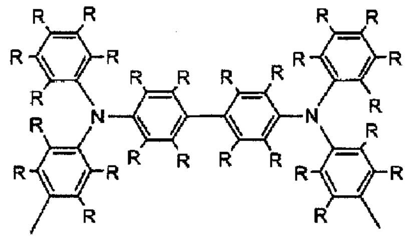
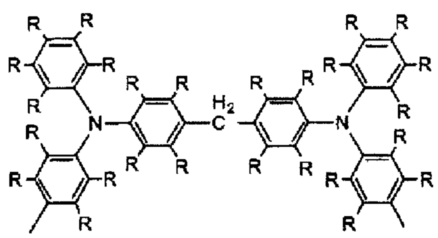
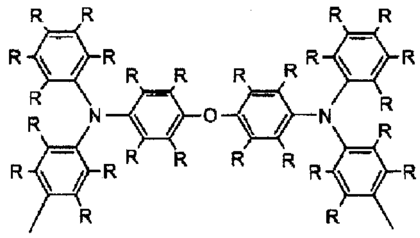
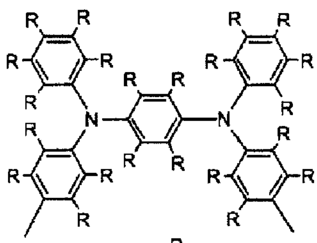
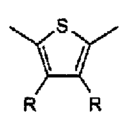
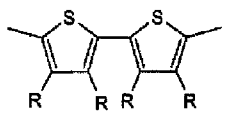
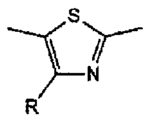
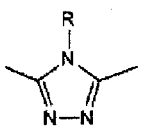
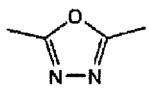
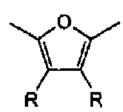
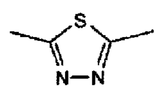
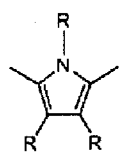
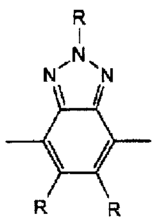
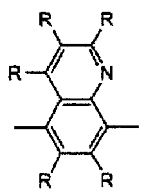
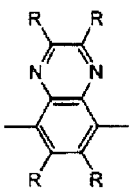
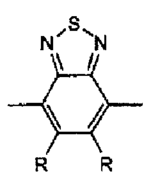
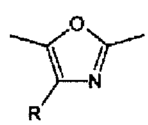
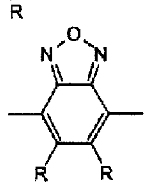
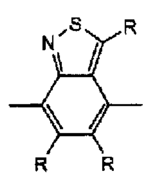
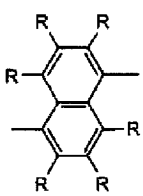

Each R independently represents a hydrogen atom or a substituent. It is preferable that each R is independently selected from a group consisting of $-R^1$, $-OR^2$, $-SR^3$, $-OCOR^4$, $-COOR^5$, $-SiR^6R^7R^8$, halogen atoms, and groups containing a polymerizable functional group described below. Each of $R^1$ to $R^8$ independently represents a hydrogen atom, a linear, cyclic or branched alkyl group of 1 to 22 carbon atoms, or an aryl group or heteroaryl group of 2 to 30 carbon atoms.

An aryl group is an atom grouping in which one hydrogen atom has been removed from an aromatic hydrocarbon. A heteroaryl group is an atom grouping in which one hydrogen atom has been removed from an aromatic heterocycle. The alkyl group may be further substituted with an aryl group or heteroaryl group of 2 to 20 carbon atoms, and the aryl group or heteroaryl group may be further substituted with a linear, cyclic or branched alkyl group of 1 to 22 carbon atoms. R is preferably a hydrogen atom, an alkyl group, an aryl group, or an alkyl-substituted aryl group. Ar represents an arylene group or heteroarylene group of 2 to 30 carbon atoms. An arylene group is an atom grouping in which two hydrogen atoms have been removed from an aromatic hydrocarbon. A heteroarylene group is an atom grouping in which two hydrogen atoms have been removed from an aromatic heterocycle. Ar is preferably an arylene group, and is more preferably a phenylene group.

In one embodiment, R may be the monovalent conjugated diene-containing group or the monovalent dienophile-containing group described above.

(Structural Unit T)

The structural unit T is a monovalent structural unit that constitutes a terminal portion of the charge transport polymer. There are no particular limitations on the structural unit T, which may be selected from among substituted or unsubstituted structures including aromatic hydrocarbon structures, aromatic heterocyclic structures, and structures containing one, or two or more, of these structures. In one embodiment, from the viewpoint of imparting durability to the polymer without impairing the charge transport properties, the structural unit T is preferably a substituted or unsubstituted aromatic hydrocarbon structure, and is more preferably a substituted or unsubstituted benzene structure. The structural unit T may have a similar structure to at least one of the structural unit L and the structural unit B, or may have a different structure.

In one embodiment, the charge transport polymer preferably has a polymerizable functional group at a terminal portion. Here, the polymerizable functional group is preferably the monovalent conjugated diene-containing group or the monovalent dienophile-containing group described above.

A specific example of the structural unit T is shown below. However, the structural unit T is not limited to the structure below.

[Chemical formula 17]

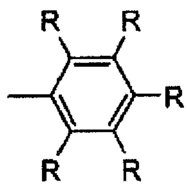

R is the same as R in the structural unit L. In those cases where the charge transport polymer has a polymerizable functional group at a terminal portion, at least one R is preferably a group containing a polymerizable functional group.

Here, the polymerizable functional group is preferably the monovalent conjugated diene-containing group or the monovalent dienophile-containing group described above. For example, the monovalent conjugated diene-containing group is preferably a monovalent furan ring-containing group, and the monovalent dienophile-containing group is preferably a monovalent maleimide-containing group or a group having a styrene structure. A more specific description is provided below.

In one embodiment, in those cases where the charge transport material has a first charge transport polymer having a conjugated diene-containing group at a terminal and a second charge transport polymer having a dienophile-containing group at a terminal, specific examples of the structural unit T1 that constitutes part of the first charge transport polymer and the structural unit T2 that constitutes part of the second charge transport polymer are shown below.

[Chemical formula 18]

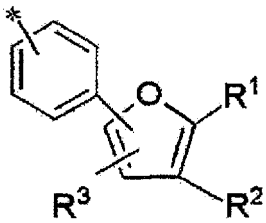

(T1a)

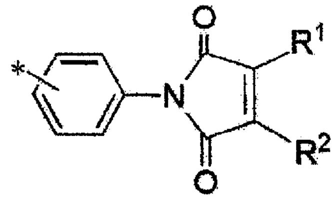

(T2a)

$R^1$ to $R^3$ in the above formula (T1a), and $R^1$ and $R^2$ in the above formula (T2a) are as described above. The symbol "*" denotes a bonding site with another structural region. Among the various structural units represented by formula (T1a), structures having the phenylene group bonded to the position adjacent to the oxygen atom of the furan ring are preferred.

Examples of the structural unit T include the monovalent conjugated diene-containing group and the monovalent dienophile-containing group described above. In other words, other examples of the structural unit T1 and the structural unit T2 include the structures shown below.

[Chemical formula 19]

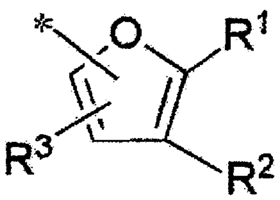

(T1b)

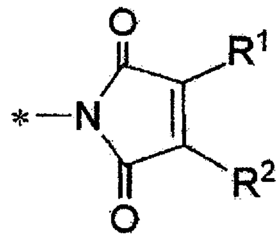

(T2b)

$R^1$ to $R^3$ in the above formula (T1b), and $R^1$ and $R^2$ in the above formula (T2b) are as described above. Among the various structural units represented by formula (T1b), structures having the bonding site with another structural region at the position adjacent to the oxygen atom of the furan ring are preferred.

In another embodiment, in those cases where the charge transport material contains a first charge transport polymer having a conjugated diene-containing group at a terminal, specific examples of the structural unit T1 that constitutes part of the first charge transport polymer include the structures shown below.

[Chemical formula 20]

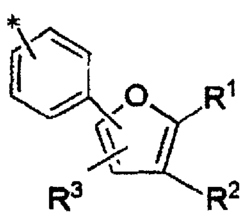

(T1a)

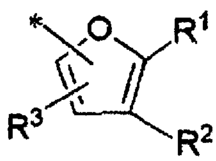

(T1b)

$R^1$ to $R^3$ in the above formulas are as described above. The symbol "*" denotes a bonding site with another structural unit. In one embodiment, it is more preferable that $R^1$ to $R^3$ each represents a hydrogen atom (namely, an unsubstituted furan ring-containing group).

Moreover, in another embodiment, in those cases where the charge transport material contains a first charge transport polymer having a conjugated diene-containing group at a terminal and a second charge transport polymer having a dienophile-containing group at a terminal, the structural unit T having a dienophile-containing group that constitutes part of the second charge transport polymer may have a styrene structure. For example, specific examples of a structural unit T3 having a styrene structure include the structures shown below. In this embodiment, the structural unit T that constitutes the first charge transport polymer having a conjugated diene-containing group at a terminal may be, for example, a structural unit (T1a) or (T1b) described above.

[Chemical formula 21]

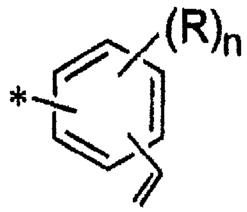

(T 3 a)

In the formula, R is as described above, and * denotes a bonding site with another structural unit. In one embodiment, it is preferable that n is 0 (namely, an unsubstituted styrene group).

(Structural Unit B)

The structural unit B is a trivalent or higher valent structural unit that constitutes a branched portion in those cases where the charge transport polymer or oligomer has a branched structure. From the viewpoint of improving the durability of organic electronic elements, the structural unit B is preferably not higher than hexavalent, and is more preferably either trivalent or tetravalent. The structural unit B is preferably a unit that has charge transport properties. For example, from the viewpoint of improving the durability of organic electronic elements, the structural unit B is preferably selected from among substituted or unsubstituted structures including aromatic amine structures, carbazole structures, condensed polycyclic aromatic hydrocarbon structures, and structures containing one, or two or more, of these structures. The structural unit B may have a similar structure to the structural unit L, or may have a different structure, or alternatively, may have a similar structure to the structural unit T, or may have a different structure.

Specific examples of the structural unit B are shown below. However, the structural unit B is not limited to the following structures.

[Chemical formula 22]

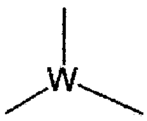
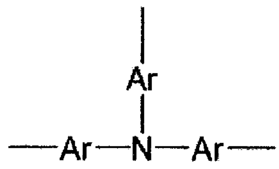
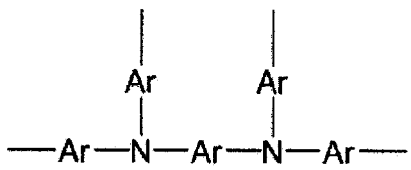

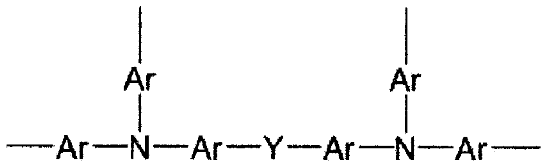
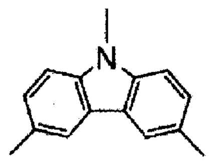
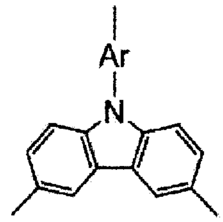

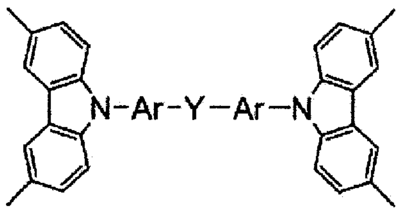
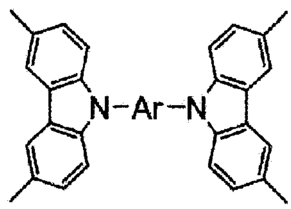

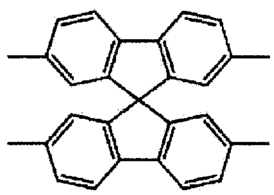
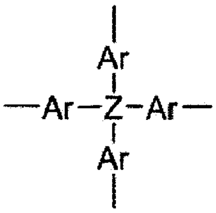
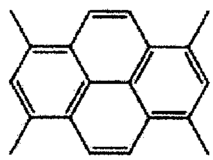

W represents a trivalent linking group, and for example, represents an arenetriyl group or heteroarenetriyl group of 2 to 30 carbon atoms. The above mentioned arenetriyl group is an atom grouping in which three hydrogen atoms have been removed from an aromatic hydrocarbon. A heteroarenetriyl group is an atom grouping in which three hydrogen atoms have been removed from an aromatic heterocycle. Each Ar independently represents a divalent linking group, and for example, independently represents an arylene group or heteroarylene group of 2 to 30 carbon atoms.

Ar preferably represents an arylene group, and more preferably a phenylene group. Y represents a divalent linking group, and examples include divalent groups in which an additional hydrogen atom has been removed from any of the R groups having one or more hydrogen atoms (but excluding groups containing a polymerizable functional group) described in relation to the structural unit L. Z represents a carbon atom, a silicon atom or a phosphorus atom. In the structural units, the benzene rings and Ar groups may each have a substituent, and examples of the substituent include the R groups in the structural unit L.

(Number Average Molecular Weight)

The number average molecular weight of the charge transport polymer can be adjusted appropriately with due consideration of the solubility in solvents and the film formability and the like. From the viewpoint of ensuring superior charge transport properties, the number average molecular weight is preferably at least 500, more preferably at least 1,000, and even more preferably 2,000 or greater. In one embodiment, the number average molecular weight is preferably at least 18,000, more preferably at least 20,000, and even more preferably 30,000 or greater. Further, from the viewpoints of maintaining favorable solubility in solvents and facilitating the preparation of ink compositions, the number average molecular weight is preferably not more than 1,000,000, more preferably not more than 100,000, and even more preferably 50,000 or less.

(Weight Average Molecular Weight)

The weight average molecular weight of the charge transport polymer can be adjusted appropriately with due consideration of the solubility in solvents and the film formability and the like. From the viewpoint of ensuring superior charge transport properties, the weight average molecular weight is preferably at least 1,000, more preferably at least 5,000, and even more preferably 10,000 or greater. Further, from the viewpoints of maintaining favorable solubility in solvents and facilitating the preparation of ink compositions, the weight average molecular weight is preferably not more than 1,000,000, more preferably not more than 700,000, even more preferably not more than 400,000, and still more preferably 300,000 or less. In one embodiment, it is particularly preferable that the weight average molecular weight of the charge transport polymer is not more than 200,000.
The number average molecular weight and the weight average molecular weight can be measured by gel permeation chromatography (GPC), using a calibration curve of standard polystyrenes.

(Proportions of Structural Units)

From the viewpoint of obtaining satisfactory charge transport properties, the proportion of the structural unit L contained in the charge transport polymer, based on the total of all the structural units, is preferably at least 10 mol%, more preferably at least 20 mol%, and even more preferably 30 mol% or higher. If the structural unit T and the optionally introduced structural unit B are taken into consideration, then the proportion of the structural unit L is preferably not more than 95 mol%, more preferably not more than 90 mol%, and even more preferably 85 mol% or less.
From the viewpoint of improving the characteristics of organic electronic elements, or from the viewpoint of suppressing any increase in viscosity and enabling more favorable synthesis of the charge transport polymer, the proportion of the structural unit T contained in the charge transport polymer, based on the total of all the structural units, is preferably at least 5 mol%, more preferably at least 10 mol%, and even more preferably 15 mol% or higher. Further, from the viewpoint of obtaining satisfactory charge transport properties, the proportion of the structural unit T is preferably not more than 60 mol%, more preferably not more than 55 mol%, and even more preferably 50 mol% or less. Here, the proportion of the structural unit T means the total amount of the structural units T1a and T1b in the case of the structural unit T1 that constitutes part of the first charge transport polymer having a conjugated diene-containing group at a terminal. Similarly, in the case of the structural unit T2, the proportion of the structural unit T means the total amount of the structural units T2a and T2b.
In those cases where the charge transport polymer includes the structural unit B, from the viewpoint of improving the durability of organic electronic elements, the proportion of the structural unit B, based on the total of all the structural units, is preferably at least 1 mol%, more preferably at least 5 mol%, and even more preferably 10 mol% or higher. Further, from the viewpoints of suppressing any increase in viscosity and enabling more favorable synthesis of the charge transport polymer, or from the viewpoint of obtaining satisfactory charge transport properties, the proportion of the structural unit B is preferably not more than 50 mol%, more preferably not more than 40 mol%, and even more preferably 30 mol% or less.
In those cases where the charge transport polymer has a polymerizable functional group, from the viewpoint of ensuring efficient curing of the charge transport polymer, the proportion of the polymerizable functional group, based on the total of all the structural units, is preferably at least 0.1 mol%, more preferably at least 1 mol%, and even more preferably 3 mol% or higher. Further, from the viewpoint of obtaining favorable charge transport properties, the proportion of the polymerizable functional group is preferably not more than 70 mol%, more preferably not more than 60 mol%, and even more preferably 50 mol% or less. Here, the "proportion of the polymerizable functional group" refers to the proportion of the structural unit having the polymerizable functional group.
Considering the balance between the charge transport properties, the durability, and the productivity and the like, the ratio (molar ratio) between the structural unit L and the structural unit T is preferably L:T = 100:(1 to 70), more preferably 100:(3 to 50), and even more preferably 100:(5 to 30). Further, in those cases where the charge transport polymer also includes the structural unit B, the ratio (molar ratio) between the structural unit L, the structural unit T and the structural unit B is preferably L:T:B = 100:(10 to 200):(10 to 100), more preferably 100:(20 to 180):(20 to 90), and even more preferably 100:(40 to 160):(30 to 80).
The proportion of each structural unit can be determined from the amount added of the monomer corresponding with that structural unit during synthesis of the charge transport polymer. Further, the proportion of each structural unit can also be calculated as an average value using the integral of the spectrum attributable to the structural unit in the $^1$H-NMR spectrum of the charge transport polymer. In terms of simplicity, if the amount added of the monomer is clear, then the proportion of the structural unit preferably employs the value determined using the amount added of the monomer.
In a particularly preferred embodiment, from the viewpoints of achieving superior hole injection properties and hole transport properties and the like, the charge transport polymer is preferably a compound containing a structural unit having an aromatic amine structure and/or a structural unit having a carbazole structure as the main structural unit

(main skeleton). Further, from the viewpoint of facilitating easier multilayering, the charge transport polymer is preferably a compound having at least two or more polymerizable functional groups.

(Production Method)

The charge transport polymer can be produced by various synthesis methods, and there are no particular limitations. For example, conventional coupling reactions such as the Suzuki coupling, Negishi coupling, Sonogashira coupling, Stille coupling and Buchwald-Hartwig coupling reactions can be used. The Suzuki coupling is a reaction in which a cross-coupling reaction is initiated between an aromatic boronic acid derivative and an aromatic halide using a Pd catalyst. By using a Suzuki coupling, the charge transport polymer can be produced easily by bonding together the desired aromatic rings.

In the coupling reaction, a Pd(0) compound, Pd(II) compound, or Ni compound or the like is used as a catalyst. Further, a catalyst species generated by mixing a precursor such as tris(dibenzylideneacetone)dipalladium(0) or palladium(II) acetate with a phosphine ligand can also be used. Reference may also be made to WO 2010/140553 in relation to synthesis methods for the charge transport polymer.

[Dopant]

The charge transport material may also contain optional additives, and for example, may also contain a dopant. There are no particular limitations on the dopant, provided it is a compound that yields a doping effect upon addition to the charge transport material, enabling an improvement in the charge transport properties. Doping includes both p-type doping and n-type doping. In p-type doping, a substance that functions as an electron acceptor is used as the dopant, whereas in n-type doping, a substance that functions as an electron donor is used as the dopant. To improve the hole transport properties, p-type doping is preferably performed, whereas to improve the electron transport properties, n-type doping is preferably performed. The dopant used in the charge transport material may be a dopant that exhibits either a p-type doping effect or an n-type doping effect. Further, a single type of dopant may be added alone, or a mixture of a plurality of dopant types may be added.

The dopants used in p-type doping are electron-accepting compounds, and examples include Lewis acids, protonic acids, transition metal compounds, ionic compounds, halogen compounds and $\pi$-conjugated compounds. Specific examples include Lewis acids such as $FeCl_3$, $PF_5$, $AsF_5$, $SbF_5$, $BF_5$, $BCl_3$ and $BBr_3$; protonic acids, including inorganic acids such as HF, HCl, HBr, $HNO_3$, $H_2SO_4$ and $HClO_4$, and organic acids such as benzenesulfonic acid, p-toluenesulfonic acid, dodecylbenzenesulfonic acid, polyvinylsulfonic acid, methanesulfonic acid, trifluoromethanesulfonic acid, trifluoroacetic acid, 1-butanesulfonic acid, vinylphenylsulfonic acid and camphorsulfonic acid; transition metal compounds such as FeOCl, $TiCl_4$, $ZrCl_4$, $HfCl_4$, $NbF_5$, $AlCl_3$, $NbCl_5$, $TaCl_5$ and $MoF_5$; ionic compounds, including salts containing a perfluoro anion such as a tetrakis(pentafluorophenyl)borate ion, tris(trifluoromethanesulfonyl)methide ion, bis(trifluoromethanesulfonyl)imide ion, hexafluoroantimonate ion, $AsF_6^-$ (hexafluoroarsenate ion), $BF_4^-$(tetrafluoroborate ion) or $PF_6^-$ (hexafluorophosphate ion), and salts having a conjugate base of an aforementioned protonic acid as an anion; halogen compounds such as $Cl_2$, $Br_2$, $I_2$, ICl, $ICl_3$, IBr and IF; and $\pi$-conjugated compounds such as TCNE (tetracyanoethylene) and TCNQ (tetracyanoquinodimethane). Further, the electron-accepting compounds disclosed in JP 2000-36390 A, JP 2005-75948 A, and JP 2003-213002 A and the like can also be used. Among the above dopants, Lewis acids, ionic compounds, and $\pi$-conjugated compounds and the like are preferred.

The dopants used in n-type doping are electron-donating compounds, and examples include alkali metals such as Li and Cs, alkaline earth metals such as Mg and Ca, salts of alkali metals and/or alkaline earth metals such as LiF and $Cs_2CO_3$, metal complexes, and electron-donating organic compounds.

Among the above dopants, ionic compounds can also function as polymerization initiators. The charge transport material disclosed in the present description is characterized by being able to be insolubilized without using a polymerization initiator, but if necessary, an ionic compound may be included in order to improve the charge transport properties.

[Other Optional Components]

The charge transport material may also contain charge transport low-molecular weight compounds, or other polymers or the like.

[Contents]

From the viewpoint of obtaining favorable charge transport properties, the amount of the charge transport polymer in the charge transport material, relative to the total mass of the charge transport material, is preferably at least 50% by mass, more preferably at least 70% by mass, and even more preferably 80% by mass or greater. There are no

particular limitations on the upper limit for the amount of the charge transport polymer, and this amount may be 100% by mass. If consideration is given to including additives such as a dopant, then the amount of the charge transport polymer is typically not more than 95% by mass, and may be 90% by mass or less.

When a dopant is included, from the viewpoint of improving the charge transport properties of the charge transport material, the amount of the dopant relative to the total mass of the charge transport material is preferably at least 0.01% by mass, more preferably at least 0.1% by mass, and even more preferably 0.5% by mass or greater. On the other hand, if the amount of the dopant is too high, then roughness of the film surface and fluctuations in the film thickness tend to occur more readily. Accordingly, the amount of the dopant relative to the total mass of the charge transport material is preferably not more than 40% by mass, more preferably not more than 30% by mass, and even more preferably 20% by mass or less.

<Ink Composition>

In one embodiment, an ink composition contains the charge transport material of an embodiment described above, and a solvent capable of dissolving or dispersing that material. By using the ink composition, an organic layer can be formed easily using a simple coating method.

[Solvent]

Water, organic solvents, or mixed solvents thereof can be used as the solvent. Examples of the organic solvent include alcohols such as methanol, ethanol and isopropyl alcohol; alkanes such as pentane, hexane and octane; cyclic alkanes such as cyclohexane; aromatic hydrocarbons such as benzene, toluene, xylene, mesitylene, tetralin and diphenylmethane; aliphatic ethers such as ethylene glycol dimethyl ether, ethylene glycol diethyl ether and propylene glycol-1-monomethyl ether acetate; aromatic ethers such as 1,2-dimethoxybenzene, 1,3-dimethoxybenzene, anisole, phenetole, 2-methoxytoluene, 3-methoxytoluene, 4-methoxytoluene, 2,3-dimethylanisole and 2,4-dimethylanisole; aliphatic esters such as ethyl acetate, n-butyl acetate, ethyl lactate and n-butyl lactate; aromatic esters such as phenyl acetate, phenyl propionate, methyl benzoate, ethyl benzoate, propyl benzoate and n-butyl benzoate; amide-based solvents such as N,N-dimethylformamide and N,N-dimethylacetamide; as well as dimethyl sulfoxide, tetrahydrofuran, acetone, chloroform and methylene chloride and the like. Among the above solvents, aromatic hydrocarbons, aliphatic esters, aromatic esters, aliphatic ethers, and aromatic ethers and the like are preferred.

[Additives]

The ink composition may also contain additives as optional components. Examples of these additives include polymerization inhibitors, stabilizers, thickeners, gelling agents, flame retardants, antioxidants, reduction inhibitors, oxidizing agents, reducing agents, surface modifiers, emulsifiers, antifoaming agents, dispersants and surfactants.

[Contents]

The amount of the solvent in the ink composition can be determined with due consideration of the use of the composition in various coating methods. For example, the amount of the solvent is preferably an amount that yields a ratio of the charge transport polymer relative to the solvent that is at least 0.1% by mass, more preferably at least 0.2% by mass, and even more preferably 0.5% by mass or greater. Further, the amount of the solvent is preferably an amount that yields a ratio of the charge transport polymer relative to the solvent that is not more than 20% by mass, more preferably not more than 15% by mass, and even more preferably 10% by mass or less.

<Organic Layer>

In one embodiment, an organic layer is a layer formed using the charge transport material or the ink composition of an embodiment described above. By using the ink composition, an organic layer can be formed favorably and simply by a coating method. Examples of the coating method include conventional methods such as spin coating methods, casting methods, dipping methods, plate-based printing methods such as relief printing, intaglio printing, offset printing, lithographic printing, relief reversal offset printing, screen printing and gravure printing, and plateless printing methods such as inkjet methods. When the organic layer is formed by a coating method, the organic layer (coating layer) obtained following coating may be dried using a hot plate or an oven to remove the solvent.

Because the charge transport polymer has a polymerizable functional group, a polymerization reaction of the charge transport polymer can be initiated by performing light irradiation or a heat treatment or the like, thereby changing the degree of solubility of the organic layer. By stacking organic layers having changed degrees of solubility, multilayering

of an organic electronic element can be performed with ease. Reference may also be made to WO 2010/140553 in relation to the method used for forming the organic layer.

The charge transport material or the ink composition of an embodiment described above that is used for forming the above organic layer contains a first charge transport polymer having a monovalent conjugated diene-containing group and a second charge transport polymer having a dienophile-containing group. As a result, by conducting a heat treatment following application of the charge transport material or ink composition, a Diels-Alder reaction proceeds between the first charge transport polymer and the second charge transport polymer, and the organic layer can be insolubilized (cured) at lower temperatures than have conventionally been possible. For example, following application of the charge transport material or ink composition, the organic layer can be satisfactorily cured even by heating at a temperature of 200°C or lower. In one embodiment, the heating temperature during curing is preferably at least 120°C, more preferably at least 130°C, and even more preferably 150°C or higher. The heating time is not particularly limited, but from the viewpoint of suppressing any deterioration in the performance of the organic layer as a result of the heating, is preferably kept to a value within 60 minutes.

For these types of reasons, in the production of an organic electronic element or an organic EL element, the organic layer can be insolubilized by applying the charge transport material or ink composition, and then conducting a heat treatment at a temperature of 120°C to 220°C. The heat treatment is more preferably conducted at a temperature of 130°C to 220°C, and even more preferably a temperature of 180°C to 210°C.

From the viewpoint of improving the efficiency of charge transport, the thickness of the organic layer obtained following drying or curing is preferably at least 0.1 nm, more preferably at least 1 nm, and even more preferably 3 nm or greater. Further, from the viewpoint of reducing the electrical resistance, the thickness of the organic layer is preferably not more than 300 nm, more preferably not more than 200 nm, and even more preferably 100 nm or less.

<Organic Electronic Element>

In one embodiment, an organic electronic element has at least one of the organic layer of the embodiment described above. Examples of the organic electronic element include an organic EL element, an organic photoelectric conversion element, and an organic transistor and the like. The organic electronic element preferably has at least a structure in which the organic layer is disposed between a pair of electrodes.

<Organic EL Element>

In one embodiment, an organic EL element has at least one of the organic layer of the embodiment described above. The organic EL element typically includes a light-emitting layer, an anode, a cathode and a substrate, and if necessary, may also have other functional layers such as a hole injection layer, an electron injection layer, a hole transport layer and an electron transport layer. Each layer may be formed by a vapor deposition method, or by a coating method. The organic EL element preferably has the organic layer described above as the light-emitting layer or as another functional layer, more preferably has the organic layer as a functional layer, and even more preferably has the organic layer as at least one of a hole injection layer and a hole transport layer.

FIG. 1 is a cross-sectional schematic view illustrating one embodiment of the organic EL element. The organic EL element in FIG. 1 is an element with a multilayer structure, and has a substrate 8, an anode 2, a hole injection layer 3, a hole transport layer 6, a light-emitting layer 1, an electron transport layer 7, an electron injection layer 5 and a cathode 4 provided in that order. Each of these layers is described below.

[Light-Emitting Layer]

Examples of the materials that can be used for the light-emitting layer include low-molecular weight compounds, polymers, and dendrimers and the like. Polymers exhibit good solubility in solvents and are suitable for coating methods, and are consequently preferred. Examples of the light-emitting material include fluorescent materials, phosphorescent materials, and thermally activated delayed fluorescent materials (TADF).

Specific examples of the fluorescent materials include low-molecular weight compounds such as perylene, coumarin, rubrene, quinacridone, stilbene, color laser dyes, aluminum complexes, and derivatives of these compounds; polymers such as polyfluorene, polyphenylene, polyphenylenevinylene, polyvinylcarbazole, fluorene-benzothiadiazole copolymers, fluorene-triphenylamine copolymers, and derivatives of these compounds; and mixtures of the above materials.

Examples of materials that can be used as the phosphorescent materials include metal complexes and the like containing a metal such as Ir or Pt or the like. Examples of Ir complexes include FIr(pic) (iridium(III) bis[(4,6-difluorophenyl)-pyridinato-N,$C^2$]picolinate) which emits blue light, $Ir(ppy)_3$ (fac-tris(2-phenylpyridine)iridium) which emits green light, and $(btp)_2Ir(acac)$ (bis[2-(2'-benzo[4,5-$\alpha$]thienyl)pyridinato-N,$C^3$]iridium(acetyl-acetonate)) and $Ir(piq)_3$ (tris(1-phe-

nylisoquinoline)iridium) which emit red light. Examples of Pt complexes include PtOEP (2,3,7,8,12,13,17,18-octaethyl-21H,23H-porphyrin-platinum) which emits red light.

When the light-emitting layer contains a phosphorescent material, a host material is preferably also included in addition to the phosphorescent material. Low-molecular weight compounds, polymers, or dendrimers can be used as this host material. Examples of the low-molecular weight compounds include CBP (4,4'-bis(9H-carbazol-9-yl)-biphenyl), mCP (1,3-bis(9-carbazolyl)benzene), CDBP (4,4'-bis(carbazol-9-yl)-2,2'-dimethylbiphenyl), and derivatives of these compounds, whereas examples of the polymers include the charge transport material of the embodiments described above, polyvinylcarbazole, polyphenylene, polyfluorene, and derivatives of these polymers.

Examples of the thermally activated delayed fluorescent materials include the compounds disclosed in Adv. Mater., 21, 4802-4906 (2009); Appl. Phys. Lett., 98, 083302 (2011); Chem. Comm., 48, 9580 (2012); Appl. Phys. Lett., 101, 093306 (2012); J. Am. Chem. Soc., 134, 14706 (2012); Chem. Comm., 48, 11392 (2012); Nature, 492, 234 (2012); Adv. Mater., 25, 3319 (2013); J. Phys. Chem. A, 117, 5607 (2013); Phys. Chem. Chem. Phys., 15, 15850 (2013); Chem. Comm., 49, 10385 (2013); and Chem. Lett., 43, 319 (2014) and the like.

[Hole Injection Layer, Hole Transport Layer]

In FIG. 1, the hole injection layer 3 and the hole transport layer 6 may be organic layers formed using the charge transport material described above, but the organic EL element of the present embodiment is not limited to this type of structure. Another organic layer besides the hole injection layer and the hole transport layer may be formed using the charge transport material.

The charge transport material described above is preferably used as the material for forming at least one of the hole injection layer and the hole transport layer, and is more preferably used as the material for at least the hole transport layer. As described above, by using an ink composition containing the charge transport material, these layers can be formed with ease.

For example, in those cases where the organic EL element has an organic layer formed using the charge transport material described above as a hole transport layer, and also has a hole injection layer, a conventional material may be used for the hole injection layer. Further, in those cases where the organic EL element has an organic layer formed using the charge transport material described above as a hole injection layer, and also has a hole transport layer, a conventional material may be used for the hole transport layer.

Examples of materials that can be used for the hole injection layer and the hole transport layer include aromatic amine-based compounds (aromatic diamines such as N,N'-di(naphthalen-1-yl)-N,N'-diphenyl-benzidine ($\alpha$-NPD)), phthalocyanine-based compounds, and thiophene-based compounds (thiophene-based conductive polymers (such as poly(3,4-ethylenedioxythiophene):poly(4-styrenesulfonate) (PEDOT:PSS) and the like)).

In those cases where a material having a triphenylamine structure is used for the hole injection layer, from the viewpoint of the energy level associated with hole transport, the charge transport material of an embodiment of the present invention can be used favorably for the hole transport layer.

[Electron Transport Layer, Electron Injection Layer]

Examples of materials that can be used for the electron transport layer and the electron injection layer include phenanthroline derivatives, bipyridine derivatives, nitro-substituted fluorene derivatives, diphenylquinone derivatives, thiopyran dioxide derivatives, condensed-ring tetracarboxylic acid anhydrides of naphthalene and perylene and the like, carbodiimides, fluorenylidenemethane derivatives, anthraquinodimethane and anthrone derivatives, oxadiazole derivatives, thiadiazole derivatives, benzimidazole derivatives, quinoxaline derivatives, and aluminum complexes. Further, the charge transport material of an embodiment described above may also be used.

[Cathode]

Examples of the cathode material include metals or metal alloys, such as Li, Ca, Mg, Al, In, Cs, Ba, Mg/Ag, LiF and CsF.

[Anode]

Metals (for example, Au) or other materials having conductivity can be used as the anode. Examples of the other materials include oxides (for example, ITO: indium oxide/tin oxide, and conductive polymers (for example, polythiophene-polystyrene sulfonate mixtures (PEDOT:PSS)).

[Substrate]

In one embodiment, the organic electronic element described above preferably also has a substrate. Glass and plastics and the like can be used as the substrate. The substrate is preferably transparent. Further, a flexible substrate having flexibility is preferred. Specifically, quartz glass and light-transmitting resin films and the like can be used favorably.
Examples of the resin films include films composed of polyethylene terephthalate, polyethylene naphthalate, polyethersulfone, polyetherimide, polyetheretherketone, polyphenylene sulfide, polyarylate, polyimide, polycarbonate, cellulose triacetate or cellulose acetate propionate.
In those cases where a resin film is used, an inorganic substance such as silicon oxide or silicon nitride may be coated onto the resin film to inhibit the transmission of water vapor and oxygen and the like.

[Encapsulation]

The organic EL element may be encapsulated to reduce the effect of the outside atmosphere and extend the life of the element. Materials that can be used for the encapsulation include, but are not limited to, glass, plastic films such as epoxy resins, acrylic resins, polyethylene terephthalate and polyethylene naphthalate, and inorganic substances such as silicon oxide and silicon nitride. There are also no particular limitations on the encapsulation method, and conventional methods may be used.

[Emission Color]

There are no particular limitations on the color of the light emission from the organic EL element. White organic EL elements can be used for various illumination fixtures, including domestic lighting, in-vehicle lighting, watches and liquid crystal backlights, and are consequently preferred.
The method used for forming a white organic EL element may employ a method in which a plurality of light-emitting materials are used to emit a plurality of colors simultaneously, which are then mixed to obtain a white light emission. There are no particular limitations on the combination of the plurality of emission colors, and examples include combinations that include three maximum emission wavelengths for blue, green and red, and combinations that include two maximum emission wavelengths for blue and yellow, or for yellowish green and orange or the like. Control of the emission color can be achieved by appropriate adjustment of the types and amounts of the light-emitting materials.

<Display Element, Illumination Device, Display Device>

In one embodiment, a display element contains the organic EL element of the embodiment described above. For example, by using the organic EL element as the element corresponding with each color pixel of red, green and blue (RGB), a color display element can be obtained. Examples of the image formation method include a simple matrix in which each of the organic EL elements arrayed in a panel are driven directly by an electrode arranged in a matrix, and an active matrix in which a thin-film transistor is positioned on, and drives, each element.
Furthermore, in one embodiment, an illumination device contains the organic EL element of the embodiment described above. Moreover, in one embodiment, a display device contains the illumination device and a liquid crystal element as a display unit. For example, the display device may be a device that uses the illumination device of the embodiment described above as a backlight, and uses a conventional liquid crystal element as the display unit, namely a liquid crystal display device.

EXAMPLES

The present invention is described below in further detail using a series of examples, but the present invention is not limited by the following examples. Unless specifically stated otherwise, "%" means "% by mass".

<Preparation of Pd Catalyst>

In a glove box under a nitrogen atmosphere at room temperature, tris(dibenzylideneacetone)dipalladium (73.2 mg, 80 μmol) was weighed into a sample tube, anisole (15 mL) was added, and the resulting mixture was agitated for 30 minutes. In a similar manner, tris(t-butyl)phosphine (129.6 mg, 640 μmol) was weighed into a sample tube, anisole (5 mL) was added, and the resulting mixture was agitated for 5 minutes. The two solutions were then mixed together and stirred for 30 minutes at room temperature to obtain a catalyst. All the solvents were deaerated by nitrogen bubbling for at least 30 minutes prior to use.

<Synthesis of Charge Transport Polymer 1>

A three-neck round-bottom flask was charged with a monomer B1 shown below (5.0 mmol), a monomer L1 shown below (10.0 mmol), a monomer T1 shown below (5.0 mmol), toluene (42.8 mL) and methyl tri-n-octyl ammonium chloride (67.2 mg), and the prepared Pd catalyst solution (15.0 mL) was then added. After stirring for 30 minutes, a 3 M aqueous solution of potassium hydroxide (13.5 mL) was added. All of the solvents were deaerated by nitrogen bubbling for at least 30 minutes prior to use. The resulting mixture was heated and refluxed for 2 hours. All the operations up to this point were conducted under a stream of nitrogen.

[Chemical formula 23]

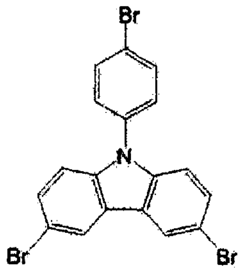

Monomer B1

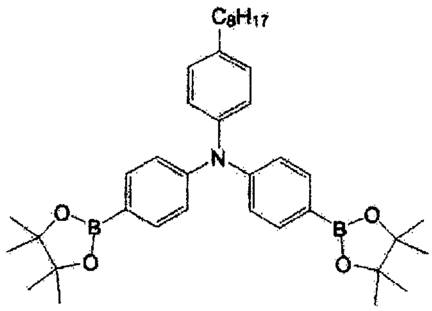

Monomer L1

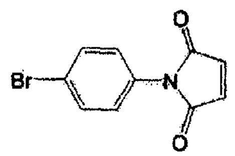

Monomer T1

After completion of the reaction, the organic layer was washed with water and then poured into methanol-water (9:1). The resulting precipitate was collected by filtration under reduced pressure, and washed with butyl acetate to obtain a precipitate. The thus obtained precipitate was collected by filtration under reduced pressure and then dissolved in toluene, and a metal adsorbent ("Triphenylphosphine, polymer-bound on styrene-divinylbenzene copolymer", manufactured by Strem Chemicals Inc., 200 mg per 100 mg of the precipitate) was then added to the solution and stirred overnight. Following completion of the stirring, the metal adsorbent and other insoluble matter were removed by filtration, and the filtrate was concentrated using a rotary evaporator. The concentrate was dissolved in toluene and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer 1.

The thus obtained charge transport polymer 1 had a number average molecular weight of 21,300 and a weight average molecular weight of 432,600. The charge transport polymer 1 had a structural unit B1, a structural unit L1 and a structural unit T1, and the proportions (molar ratios) of those structural units were 25.1%, 50.1% and 24.8% respectively.

The number average molecular weight and weight average molecular weight of the charge transport polymer 1 were measured by GPC (relative to polystyrene standards) using tetrahydrofuran (THF) as the eluent. The measurement conditions were as follows. The number average molecular weight and weight average molecular weight for each of the polymers described below were measured in the same manner.

Feed pump: L-6050, manufactured by Hitachi High-Technologies Corporation
UV-Vis detector: L-3000, manufactured by Hitachi High-Technologies Corporation
Columns: Gelpack (a registered trademark) GL-A160S / GL-A150S, manufactured by Hitachi Chemical Co., Ltd.
Eluent: THF (for HPLC, stabilizer-free), manufactured by Wako Pure Chemical Industries, Ltd.
Flow rate: 1 ml/min
Column temperature: room temperature
Molecular weight standards: standard polystyrenes

<Synthesis of Charge Transport Polymer 2>

A three-neck round-bottom flask was charged with the monomer B1 shown above (5.0 mmol), the monomer L1 shown above (10.0 mmol), the monomer T1 shown above (5.0 mmol), toluene (99.2 mL) and methyl tri-n-octyl ammonium chloride (67.2 mg), and the prepared Pd catalyst solution (15.0 mL) was then added. Thereafter, a charge transport polymer 2 was synthesized in the same manner as the synthesis of the charge transport polymer 1.

The thus obtained charge transport polymer 2 had a number average molecular weight of 30,800 and a weight average molecular weight of 196,900. The charge transport polymer 2 had a structural unit B1, a structural unit L1 and a structural unit T1, and the proportions (molar ratios) of those structural units were 24.9%, 50.2% and 24.9% respectively.

<Synthesis of Charge Transport Polymer 3>

A three-neck round-bottom flask was charged with the monomer B1 shown above (5.0 mmol), the monomer L1 shown above (10.0 mmol), a monomer T2 shown below (5.0 mmol), toluene (176.7 mL) and methyl tri-n-octyl ammonium chloride (67.2 mg), and the prepared Pd catalyst solution (15.0 mL) was then added. Thereafter, a charge transport polymer 3 was synthesized in the same manner as the synthesis of the charge transport polymer 1.

[Chemical formula 24]

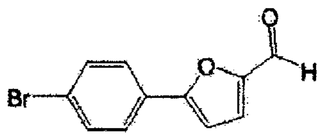

Monomer T2

The thus obtained charge transport polymer 3 had a number average molecular weight of 25,500 and a weight average molecular weight of 198,800. The charge transport polymer 3 had a structural unit B1, a structural unit L1 and a structural unit T2, and the proportions (molar ratios) of those structural units were 24.7%, 50.1% and 25.2% respectively.

<Synthesis of Charge Transport Polymer 4>

A three-neck round-bottom flask was charged with the monomer B1 shown above (4.0 mmol), the monomer L1 shown above (10.0 mmol), a monomer T3 shown below (8.0 mmol), toluene (80.1 mL) and methyl tri-n-octyl ammonium chloride (67.2 mg), and the prepared Pd catalyst solution (15.0 mL) was then added. Thereafter, a charge transport polymer 4 was synthesized in the same manner as the synthesis of the charge transport polymer 1.

[Chemical formula 25]

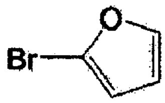

Monomer T3

The thus obtained charge transport polymer 4 had a number average molecular weight of 18,200 and a weight average molecular weight of 40,300. The charge transport polymer 4 had a structural unit B1, a structural unit L1 and a structural unit T3, and the proportions (molar ratios) of those structural units were 18.2%, 45.4% and 36.4% respectively.

<Synthesis of Charge Transport Polymer 5>

A three-neck round-bottom flask was charged with the monomer B1 shown above (4.0 mmol), the monomer L1 shown above (10.0 mmol), a monomer T4 shown below (2.0 mmol), a monomer T5 shown below (3.0 mmol), toluene (62.4 mL) and methyl tri-n-octyl ammonium chloride (67.2 mg), and the prepared Pd catalyst solution (15.0 mL) was then added. Thereafter, a charge transport polymer 5 was synthesized in the same manner as the synthesis of the charge transport polymer 1.

[Chemical formula 26]

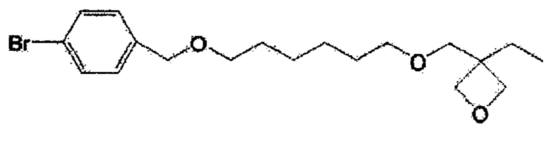

Monomer T4

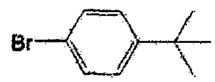

Monomer T5

The thus obtained charge transport polymer 5 had a number average molecular weight of 17,200 and a weight average molecular weight of 45,900. The charge transport polymer 5 had a structural unit B1, a structural unit L1, a structural unit T4 and a structural unit T5, and the proportions (molar ratios) of those structural units were 18.1%, 45.3%, 27.4% and 9.2% respectively.

<Synthesis of Charge Transport Polymer 6>

A three-neck round-bottom flask was charged with the monomer B1 shown above (4.0 mmol), a monomer L2 shown below (10.0 mmol), the monomer T4 shown above (8.0 mmol), toluene (54.1 mL) and methyl tri-n-octyl ammonium chloride (67.2 mg), and the prepared Pd catalyst solution (15.0 mL) was then added. Thereafter, a charge transport polymer 6 was synthesized in the same manner as the synthesis of the charge transport polymer 1.

[Chemical formula 27]

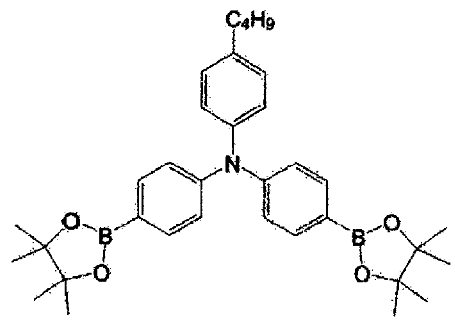

Monomer L2

The thus obtained charge transport polymer 6 had a number average molecular weight of 21,700 and a weight average molecular weight of 67,200. The charge transport polymer 6 had a structural unit L2, a structural unit B1 and a structural unit T4 having an oxetane group, and the proportions (molar ratios) of those structural units were 45.6%, 18.1% and 36.4% respectively.

<Synthesis of Charge Transport Polymer 1A>

A three-neck round-bottom flask was charged with a monomer B1 shown below (4.0 mmol), a monomer L1 shown below (10.0 mmol), a monomer T6 shown below (8.0 mmol), toluene (100.2 mL) and methyl tri-n-octyl ammonium chloride (134.4 mg), and the prepared Pd catalyst solution (2.0 mL) was then added. After stirring for 30 minutes, a 3 M aqueous solution of potassium hydroxide (13.5 mL) was added. All of the monomers used as raw materials were deaerated in the form of toluene solutions by nitrogen bubbling for at least 30 minutes prior to use. The mixture of the above raw materials (the toluene solution) was heated and refluxed for 2 hours. All the operations up to this point were conducted under a stream of nitrogen.

[Chemical formula 28]

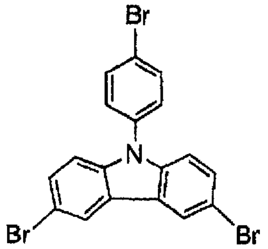

Monomer B1

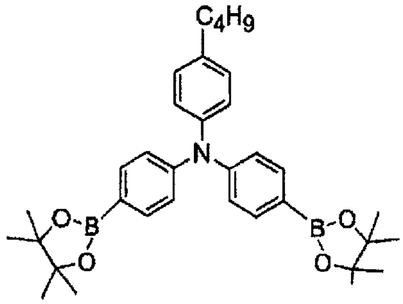

Monomer L1

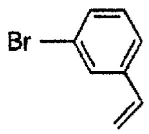

Monomer T6

After completion of the reaction, the organic layer was washed with water and then poured into methanol-water (9:1). The resulting precipitate was collected by filtration under reduced pressure, and washed with butyl acetate to obtain a precipitate. The thus obtained precipitate was collected by filtration under reduced pressure and then dissolved in toluene, and a metal adsorbent ("Triphenylphosphine, polymer-bound on styrene-divinylbenzene copolymer", manufactured by Strem Chemicals Inc., 200 mg per 100 mg of the precipitate) was then added to the solution and stirred overnight. Following completion of the stirring, the metal adsorbent and other insoluble matter were removed by filtration, and the filtrate was concentrated using a rotary evaporator. The concentrate was dissolved in toluene and then re-precipitated from methanol-acetone (8:3). The thus produced precipitate was collected by filtration under reduced pressure and washed with methanol-acetone (8:3). The thus obtained precipitate was then dried under vacuum to obtain a charge transport polymer 1A.

The thus obtained charge transport polymer 1A had a number average molecular weight of 15,700 and a weight average molecular weight of 41,600. The charge transport polymer 1A had a structural unit B1, a structural unit L1 and a structural unit T6, and the proportions (molar ratios) of those structural units were 18.3%, 45.5% and 36.2% respectively.

<Synthesis of Charge Transport Polymer 2A>

A three-neck round-bottom flask was charged with the monomer B1 shown above (4.0 mmol), the monomer L1 shown above (10.0 mmol), a monomer T3 shown below (8.0 mmol), toluene (87.3 mL) and methyl tri-n-octyl ammonium chloride (134.4 mg), and the prepared Pd catalyst solution (2.0 mL) was then added. Thereafter, a charge transport polymer 2A was synthesized in the same manner as the synthesis of the charge transport polymer 1A.

[Chemical formula 29]

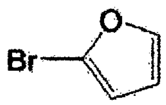

Monomer T3

The thus obtained charge transport polymer 2A had a number average molecular weight of 16,500 and a weight average molecular weight of 56,800. The charge transport polymer 2A had a structural unit B1, a structural unit L1 and a structural unit T3, and the proportions (molar ratios) of those structural units were 18.1%, 45.5% and 36.4% respectively.

<Synthesis of Charge Transport Polymer 3A>

A three-neck round-bottom flask was charged with a monomer B2 shown below (4.0 mmol), the monomer L1 shown above (10.0 mmol), the monomer T6 shown above (8.0 mmol), toluene (90.4 mL) and methyl tri-n-octyl ammonium chloride (134.4 mg), and the prepared Pd catalyst solution (2.0 mL) was then added. Thereafter, a charge transport polymer 3A was synthesized in the same manner as the synthesis of the charge transport polymer 1A.

[Chemical formula 30]

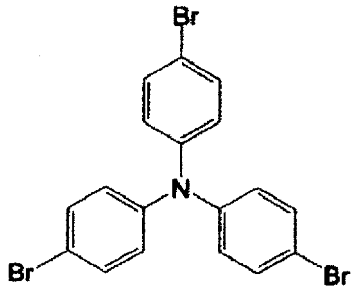

Monomer B2

The thus obtained charge transport polymer 3A had a number average molecular weight of 11,400 and a weight average molecular weight of 49,000. The charge transport polymer 3A had a structural unit B2, a structural unit L1 and a structural unit T6, and the proportions (molar ratios) of those structural units were 18.0%, 45.3% and 36.7% respectively.

<Synthesis of Charge Transport Polymer 4A>

A three-neck round-bottom flask was charged with the monomer B2 shown above (4.0 mmol), the monomer L1 shown above (10.0 mmol), the monomer T3 shown above (8.0 mmol), toluene (78.3 mL) and methyl tri-n-octyl ammonium chloride (134.4 mg), and the prepared Pd catalyst solution (2.0 mL) was then added. Thereafter, a charge transport polymer 4A was synthesized in the same manner as the synthesis of the charge transport polymer 1A.

The thus obtained charge transport polymer 4A had a number average molecular weight of 11,200 and a weight average molecular weight of 61,400. The charge transport polymer 4A had a structural unit B2, a structural unit L1 and a structural unit T3, and the proportions (molar ratios) of those structural units were 18.2%, 45.6% and 36.2% respectively.

<Synthesis of Charge Transport Polymer 5A>

A three-neck round-bottom flask was charged with the monomer B1 shown above (4.0 mmol), the monomer L1 shown above (10.0 mmol), a monomer T4 shown below (8.0 mmol), toluene (54.1 mL) and methyl tri-n-octyl ammonium chloride (134.4 mg), and the prepared Pd catalyst solution (2.0 mL) was then added. Thereafter, a charge transport polymer 5A was synthesized in the same manner as the synthesis of the charge transport polymer 1A.

[Chemical formula 31]

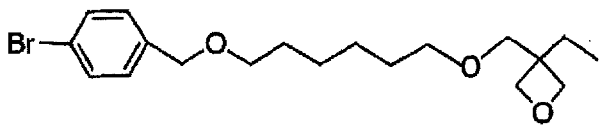

Monomer T4

The thus obtained charge transport polymer 5A had a number average molecular weight of 21,700 and a weight average molecular weight of 67,200. The charge transport polymer 5A had a structural unit B1, a structural unit L1 and a structural unit T4 having an oxetane group, and the proportions (molar ratios) of those structural units were 18.1%, 45.6% and 36.4% respectively.

<Example 1A>

A coating solution prepared by dissolving the obtained charge transport polymer 1 (10.0 mg) in toluene (2,000 μL) was spin-coated at 3,000 rpm onto a quartz plate. The quartz plate was then heated on a hot plate at 230°C for 30 minutes to initiate a polymerization reaction and form a polymer layer. Following heating, the quartz plate with the polymer

layer formed on the surface was washed by immersion in toluene solvent for one minute. Measurement of the residual film ratio, based on the ratio between the absorbance values (Abs) at the absorption maximum (λmax) in the UV-vis spectrum before and after the immersion, yielded a result of 94.8%.

$$\text{Residual film ratio (\%)} = \text{Abs after immersion} / \text{Abs before immersion} \times 100$$

From the viewpoint of satisfactorily laminating other layers of the element, the residual film ratio is preferably at least 89%.

Further, with the exception of altering the heating conditions on the hot plate, the residual film ratio was measured for a series of polymer layers in the same manner as above. The results are shown in Table 1.

<Example 2A>

With the exception of using the charge transport polymer 2 (10.0 mg) instead of the charge transport polymer 1, polymer layers were formed and the residual film ratios were measured in the same manner as Example 1A. The results are shown in Table 1.

<Example 3A>

With the exception of using the charge transport polymer 3 (10.0 mg) instead of the charge transport polymer 1, polymer layers were formed and the residual film ratios were measured in the same manner as Example 1A. The results are shown in Table 1.

<Example 4A>

With the exception of using the charge transport polymer 4 (10.0 mg) instead of the charge transport polymer 1, polymer layers were formed and the residual film ratios were measured in the same manner as Example 1A. The results are shown in Table 1.

<Comparative Example 1A>

With the exception of using the charge transport polymer 5 (10.0 mg) instead of the charge transport polymer 1, polymer layers were formed and the residual film ratios were measured in the same manner as Example 1A. The results are shown in Table 1.

<Comparative Example 2A>

With the exception of using the charge transport polymer 6 (10.0 mg) instead of the charge transport polymer 1, polymer layers were formed and the residual film ratios were measured in the same manner as Example 1A. The results are shown in Table 1.

[Table 1]

| | | Example 1A | Example 2A | Example 3A | Example 4A | Comparative Example 1A | Comparative Example 2A |
|---|---|---|---|---|---|---|---|
| Charge transport material | Charge transport polymer (mol% of polymerizable functional group) | Polymer 1 (24.8%) | Polymer 2 (24.9%) | Polymer 3 (25.2%) | Polymer 4 (36.4%) | Polymer 5 (27.4%) | Polymer 6 (36.4%) |

(continued)

| | | Example 1A | Example 2A | Example 3A | Example 4A | Comparative Example 1A | Comparative Example 2A |
|---|---|---|---|---|---|---|---|
| Residual film ratio (%) | 230°C / 30 minutes | 94.0 | 94.1 | 99.8 | 100.0 | 55.6 | 95.3 |
| | 200°C / 30 minutes | 89.2 | 89.1 | 96.1 | 100.0 | 48.1 | 88.7 |
| | 180°C / 30 minutes | 83.4 | 79.9 | 93.1 | 100.0 | 40.9 | 83.7 |
| | 150°C / 30 minutes | 73.4 | 67.3 | 89.2 | 81.0 | 38.2 | 72.2 |
| | 120°C / 30 minutes | not measured | not measured | 88.6 | 85.6 | 34.7 | 60.8 |

Note: the mol% values for the polymerizable functional groups recorded in Table 1 correspond with the proportion of the structural unit T having a polymerizable functional group within the charge transport polymer.

Based on comparisons of Examples 1A to 3A and Comparative Example 1A, and comparison of Example 4A and Comparative Example 2A, it is evident that charge transport polymers having a monovalent dienophile-containing group or a monovalent conjugated diene-containing group as a polymerizable functional group can be satisfactorily insolubilized at a lower temperature than charge transport polymers having an oxetane group as a polymerizable functional group. In particular, as can be seen in Example 3A and Example 4A, charge transport polymers having a monovalent conjugated diene-containing group (furan ring-containing group) as a polymerizable functional group are able to produce a residual film ratio exceeding 80% even under low-temperature conditions of about 120°C.

The effects of embodiments of the present invention have been demonstrated above using a series of examples. Besides the charge transport polymers used in the examples, other charge transport polymers having at least one of the monovalent conjugated diene-containing group and monovalent dienophile-containing group described above are also able to be insolubilized without using a polymerization initiator, at lower temperatures than have conventionally been possible. Further, by using a charge transport material containing the types of charge transport polymers described above, it is thought that because an organic layer that has been insolubilized at low temperature can be formed without including a polymerization initiator, high-performance organic EL elements can be provided in which any deterioration in the performance of adjacent layers has been suppressed.

<Example 1B>

A coating solution prepared by dissolving the obtained charge transport polymer 1 (5.0 mg) and charge transport polymer 3 (5.0 mg) in toluene (2,000 μL) was spin-coated at 3,000 rpm onto a quartz plate. The quartz plate was then heated on a hot plate at 150°C for 30 minutes to initiate a polymerization reaction and form a polymer layer. Following heating, the quartz plate with the polymer layer formed on the surface was washed by immersion in toluene solvent for one minute. Measurement of the residual film ratio, based on the ratio between the absorbance values (Abs) at the absorption maximum (λmax) in the UV-vis spectrum before and after the immersion, yielded a result of 96.2%.

$$\text{Residual film ratio (\%)} = \text{Abs after immersion} / \text{Abs before immersion} \times 100$$

From the viewpoint of satisfactorily laminating other layers of the element, the residual film ratio is preferably at least 95.0%. Further, with the exception of altering the heating conditions on the hot plate, the residual film ratio was measured for a series of polymer layers in the same manner as above. The results are shown below in Table 2.

<Example 2B>

With the exception of using the charge transport polymer 2 (5.0 mg) and the charge transport polymer 4 (5.0 mg) instead of the charge transport polymer 1 and the charge transport polymer 3, polymer layers were formed and the residual film ratios were measured in the same manner as Example 1B. The results are shown below in Table 2.

<Comparative Example 1B>

With the exception of using the charge transport polymer 5 (10.0 mg) and an electron-accepting compound 1 shown below (0.5 mg) that functions as a polymerization initiator instead of using the charge transport polymer 1 and the charge transport polymer 3, the residual film ratios were measured in the same manner as Example 1B. The results are shown below in Table 2.

[Chemical formula 32]

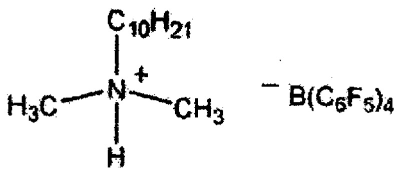

Electron-accepting compound 1

<Comparative Example 2B>

With the exception of using the charge transport polymer 6 (10.0 mg) and the electron-accepting compound 1 (0.5 mg) that functions as a polymerization initiator instead of using the charge transport polymer 1 and the charge transport polymer 3, polymer layers were formed and the residual film ratios were measured in the same manner as Example 1B. The results are shown below in Table 2.

[Table 2]

| | | Example 1B | Example 2B | Comparative Example 1B | Comparative Example 2B |
|---|---|---|---|---|---|
| Charge transport material | Charge transport polymer | Polymer 1 + Polymer 3 | Polymer 2 + Polymer 4 | Polymer 5 | Polymer 6 |
| | Polymerization initiator | none | none | Electron-accepting compound 1 | Electron-accepting compound 1 |
| Residual film ratio (%) | 230°C / 30 minutes | 100.0 | 100.0 | 99.6 | 99.1 |
| | 200°C / 30 minutes | 100.0 | 100.0 | 99.5 | 98.6 |
| | 180°C / 30 minutes | 99.7 | 100.0 | 91.8 | 98.5 |
| | 150°C / 30 minutes | 96.2 | 100.0 | 73.3 | 99.1 |
| | 120°C / 30 minutes | 88.2 | 100.0 | 19.2 | 90.4 |

A satisfactory insolubilization result was obtained at 150°C / 30 minutes in Example 1B, and at 120°C / 30 minutes in Example 2B. Based on these results, it is evident the Example 1B and the Example 2B were able to be insolubilized satisfactorily at a lower temperature than Comparative Example 1B. In particular, the embodiment of Example 2B yielded a higher residual film ratio under all of the heating conditions, even when compare with Comparative Example 2B which used a polymerization initiator and contained an increased proportion of oxetane groups. Based on these results, it is evident that by using a charge transport material of an embodiment of the present invention, insolubilization can be achieved at lower temperatures without using a polymerization initiator.

Moreover, it is evident that by employing embodiments such as Example 1B and Example 2B that use a combination of a charge transport polymer having a conjugated diene-containing group and a charge transport polymer

having a dienophile-containing group, insolubilization can be achieved at an even lower temperature than embodiments that use only one of the charge transport polymers. Specifically, in Examples 1A and 3A shown above in Table 1, achieving satisfactory insolubilization at a temperature of 150°C or lower is difficult, whereas in Examples 1B and 2B shown in Table 2, satisfactory insolubilization can be achieved even at a temperature of 150°C or lower.

Based on the above results, it is evident that by using a combination of a charge transport polymer having a conjugated diene-containing group and a charge transport polymer having a dienophile-containing group, favorable insolubilization can be achieved even at low temperatures of 150°C or lower.

<Example 1C>

A coating solution prepared by dissolving the charge transport polymer 1A (5.0 mg) and the charge transport polymer 2A (5.0 mg) in toluene (2,000 μL) was spin-coated at 3,000 rpm onto a quartz plate to form a thin film. The quartz plate having the thin film formed thereon was then placed on a hot plate and heated at 150°C for 30 minutes to cure the thin film (by polymerizing the polymer). The quartz plate with a cured thin film on the surface obtained in this manner was washed by immersion in toluene solvent for one minute. Measurement of the residual film ratio, determined in accordance with (formula 1) shown below based on the ratio between the absorbance values (Abs) at the absorption maximum (λmax) in the UV-vis spectrum before and after the immersion, yielded a result of 91.0%.

(Formula 1)

Residual film ratio (%) = Abs after immersion / Abs before immersion × 100

With the exception of altering the above heating conditions (150°C) used during the cured thin film formation to 120°C, 180°C, 200°C and 230°C respectively, cured thin films were formed and the residual film ratios were measured in the same manner as described above. The results are shown in Table 3. From the viewpoint of enabling multilayering to be performed using wet processes, the residual film ratio is preferably at least 90.0%.

Examples 2C to 5C described below relate to embodiments in which the weight ratio between the charge transport polymer 1A and the charge transport polymer 2A was altered to 2:8, 4:6, 6:4 and 8:2 respectively, without changing the total weight of the charge transport polymer 1A and the charge transport polymer 2A from Example 1C.

<Example 2C>

With the exception of changing the weights of the charge transport polymer 1A and the charge transport polymer 2A to (2.0 mg) and (8.0 mg) respectively, cured thin films were formed and the residual film ratios of those films were measured in exactly the same manner as Example 1C. The results are shown in Table 3.

<Example 3C>

With the exception of changing the weights of the charge transport polymer 1A and the charge transport polymer 2A to (4.0 mg) and (6.0 mg) respectively, cured thin films were formed and the residual film ratios of those films were measured in exactly the same manner as Example 1C. The results are shown in Table 3.

<Example 4C>

With the exception of changing the weights of the charge transport polymer 1A and the charge transport polymer 2A to (6.0 mg) and (4.0 mg) respectively, cured thin films were formed and the residual film ratios of those films were measured in exactly the same manner as Example 1C. The results are shown in Table 3.

<Example 5C>

With the exception of changing the weights of the charge transport polymer 1A and the charge transport polymer 2A to (8.0 mg) and (2.0 mg) respectively, cured thin films were formed and the residual film ratios of those films were measured in exactly the same manner as Example 1C. The results are shown in Table 3.

<Example 6C>

With the exception of using the charge transport polymer 3A (5.0 mg) and the charge transport polymer 4A (5.0 mg) instead of the charge transport polymer 1A and the charge transport polymer 2A, cured thin films were formed

and the residual film ratios of those films were measured in exactly the same manner as Example 1C. The results are shown in Table 3.

<Comparative Example 1C>

With the exception of using the charge transport polymer 5A (10.0 mg) instead of the charge transport polymer 1A and the charge transport polymer 2A, cured thin films were formed and the residual film ratios of those films were measured in exactly the same manner as Example 1C. The results are shown in Table 3.

[Table 3]

| Item | | Example 1C | | Example 2C | | Example 3C | | Example 4C | | Example 5C | | Example 6C | | Comparative Example 1C |
|---|---|---|---|---|---|---|---|---|---|---|---|---|---|---|
| Charge transport polymer | | 1A | 2A | 1A | 2A | 1A | 2A | 1A | 2A | 1A | 2A | 3A | 4A | 5A |
| Ratio (%) | | 50 | 50 | 20 | 80 | 40 | 60 | 60 | 40 | 80 | 20 | 50 | 50 | 100 |
| Residual film ratio (% ) | 230°C/30 min | - | | - | | - | | - | | - | | - | | 95.3 |
| | 200°C/30 min | 100.0 | | 98.0 | | 100.0 | | 99.5 | | 97.7 | | 98.5 | | 88.7 |
| | 180°C/30 min | 98.5 | | 99.5 | | 98.8 | | 97.8 | | 90.9 | | 95.3 | | 83.7 |
| | 150°C/30 min | 91.0 | | 90.5 | | 90.6 | | 88.6 | | 84.1 | | 89.0 | | 72.2 |
| | 120°C/30 min | 82.0 | | 90.3 | | 84.5 | | 82.9 | | 77.2 | | 88.1 | | 60.8 |

Based on the results shown in Table 3, it is evident that by using a charge transport material of an embodiment of the present invention containing a charge transport polymer having a conjugated diene-containing group and a charge transport polymer having a dienophile-containing group, insolubilization can be achieved at lower temperatures, without using a polymerization initiator.

More specifically, satisfactory insolubilization of the charge transport polymer was able to be achieved under heating conditions of 150°C / 30 minutes in Example 1C and Example 3C, under heating conditions of 120°C / 30 minutes in Example 2C, and under heating conditions of 180°C / 30 minutes in Example 4C, Example 5C and Example 6C.

In contrast, as is evident from the results for Comparative Example 1C, with a typical conventional charge transport polymer having an oxetane group as a polymerizable functional group, achieving satisfactory insolubilization without using a polymerization initiator is difficult at temperatures less than 200°C.

The effects of embodiments of the present invention have been demonstrated above using a series of examples. However, it should be evident that besides the charge transport polymers used in the examples, insolubilization at lower temperatures than have conventionally been possible can be achieved, without using a polymerization initiator, by using a charge transport material that includes both a first charge transport polymer having a conjugated diene-containing group described above, and a second charge transport polymer having a dienophile-containing group that is complementary to the above conjugated diene-containing group. Further, because any deterioration in the performance of adjacent layers can also be suppressed, high-performance organic EL elements can be provided.

DESCRIPTION OF THE REFERENCE SIGNS

1: Light-emitting layer
2: Anode
3: Hole injection layer
4: Cathode
5: Electron injection layer
6: Hole transport layer
7: Electron transport layer
8: Substrate

## Claims

1. A charge transport material comprising at least one charge transport polymer selected from the group consisting of a first charge transport polymer having one or more monovalent conjugated diene-containing groups, and a second charge transport polymer having one or more monovalent dienophile-containing groups.

2. The charge transport material according to Claim 1, wherein the first charge transport polymer and the second charge transport polymer each have a structure that is branched in three or more directions.

3. The charge transport material according to Claim 1 or 2, wherein the first charge transport polymer and the second charge transport polymer each have one or more structures selected from the group consisting of substituted or unsubstituted aromatic amine structures, carbazole structures, thiophene structures, benzene structures and fluorene structures.

4. The charge transport material according to any one of Claims 1 to 3, wherein the charge transport material has hole injection properties or hole transport properties.

5. The charge transport material according to any one of Claims 1 to 4, wherein at least one monovalent conjugated diene-containing group exists at a terminal of the first charge transport polymer, and at least one dienophile-containing group exists at a terminal of the second charge transport polymer.

6. The charge transport material according to any one of Claims 1 to 5, wherein the monovalent conjugated diene-containing group is a monovalent furan ring-containing group having a structure represented by formula (I) shown below:

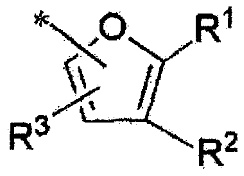

(I)

wherein each of $R^1$ to $R^3$ independently represents a group selected from the group consisting of -H, $-C_nH_{2n+1}$ (wherein n is an integer of 1 to 6), -C(=O)H, $-CH_2OH$, -Br and -Cl, and "*" denotes a bonding site with another structural region.

**7.** The charge transport material according to any one of Claims 1 to 6, wherein the monovalent dienophile-containing group is a monovalent maleimide ring-containing group having a structure represented by formula (II-1) shown below:

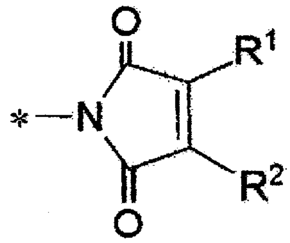

(II-1)

wherein each of $R^1$ and $R^2$ independently represents a group selected from the group consisting of -H and - $C_nH_{2n+1}$ (wherein n is an integer of 1 to 6), $R^1$ and $R^2$ may be linked together to form a ring, and "*" denotes a bonding site with another structural region.

**8.** The charge transport material according to any one of Claims 1 to 6, wherein the charge transport material comprises the first charge transport polymer.

**9.** The charge transport material according to any one of Claims 1 to 7, wherein the charge transport material comprises the first charge transport polymer and the second charge transport polymer.

**10.** The charge transport material according to any one of Claims 1 to 6, wherein the charge transport material comprises the first charge transport polymer and the second charge transport polymer, and the monovalent dienophile-containing group has a styrene structure represented by formula (III) shown below:

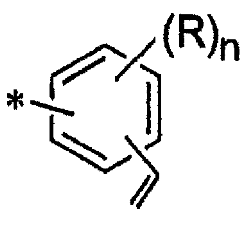

(III)

wherein each R independently represents an alkyl group of 1 to 6 carbon atoms, n represents an integer of 0 to 4, and * denotes a bonding site with another structural region.

**11.** An ink composition comprising the charge transport material according to any one of Claims 1 to 10, and a solvent.

**12.** An organic electronic element having an organic layer formed using the charge transport material according to any one of Claims 1 to 10, or the ink composition according to Claim 11.

**13.** An organic electroluminescent element having an organic layer formed using the charge transport material according to any one of Claims 1 to 10, or the ink composition according to Claim 11.

**14.** The organic electroluminescent element according to Claim 13, also having a flexible substrate.

**15.** The organic electroluminescent element according to Claim 14, wherein the flexible substrate comprises a resin film.

**16.** A display element comprising the organic electroluminescent element according to any one of Claims 13 to 15.

**17.** An illumination device comprising the organic electroluminescent element according to any one of Claims 13 to 15.

**18.** A display device comprising the illumination device according to Claim 17, and a liquid crystal element as a display unit.

FIG. 1

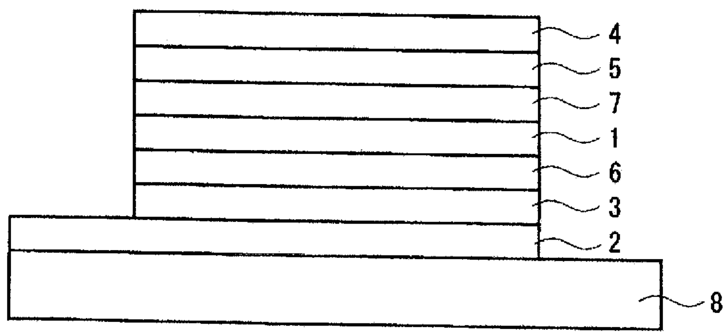

## INTERNATIONAL SEARCH REPORT

International application No. PCT/JP2018/009887

**A. CLASSIFICATION OF SUBJECT MATTER**

Int.Cl. H01L51/50(2006.01)i, C08G61/12(2006.01)i, G02F1/13357(2006.01)i, H01L27/32(2006.01)i, H05B33/02(2006.01)i

According to International Patent Classification (IPC) or to both national classification and IPC

**B. FIELDS SEARCHED**

Minimum documentation searched (classification system followed by classification symbols)
Int.Cl. H01L51/50, C08G61/12, G02F1/13357, H01L27/32, H05B33/02

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)
CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| X<br>A | PATEL et al., "A Diels-Alder crosslinkable host polymer for improved FLED performance: the impact on solution processed doped device and multilayer device performance", Journal of Materials Chemistry, vol. 22/no. 7, The Royal Society of Chemistry, 21 February 2012, pp. 3004-3014 | 1, 3-9, 11-18<br>2, 10 |
| X<br>A | JP 2013-229614 A (HITACHI CHEMICAL CO., LTD.) 07 November 2013, claims, paragraphs [0021]-[0080], [0109]-[0120], [0131]¬-[0132], [0135] & US 2014/0231791 A1, claims, paragraphs [0028]-[0068], [0098]-[0111], [0122]-[0123], [0126] & WO 2013/047581 A1 & EP 2762514 A1 & TW 201319114 A & CN 103827165 A & KR 10-2014-0068103 A | 1-5, 8, 11-18<br>6-7, 9-10 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>06 June 2018 (06.06.2018) | Date of mailing of the international search report<br>19 June 2018 (19.06.2018) |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

INTERNATIONAL SEARCH REPORT

International application No. PCT/JP2018/009887

C (Continuation). DOCUMENTS CONSIDERED TO BE RELEVANT

| Category* | Citation of document, with indication, where appropriate, of the relevant passages | Relevant to claim No. |
|---|---|---|
| X<br>A | JP 2014-019755 A (HITACHI CHEMICAL CO., LTD.) 03 February 2014, claims, paragraphs [0002], [0083]-[0109] (Family: none) | 1-5, 8, 11-18<br>6-7, 9-10 |
| X<br>A | WO 2016/026123 A1 (DOW GLOBAL TECHNOLOGIES LLC) 25 February 2016, claims, page 29, line 15 to page 30, line 7, page 31, line 18 to page 32, line 8 & JP 2017-532769 A & EP 3183285 A1 & TW 201617375 A & CN 106574040 A & KR 10-2017-0043558 A | 1-5, 11-18<br>6-10 |
| X<br>A | YAN, Zhao et al., "White light-emitting devices based on star-shape like polymers with diarylmaleimde fluorophores on the side chain of polyfluorene arms", Organic Electronics, vol. 31, ELSEVIER B. V., 01 February 2016, pp. 183-190 | 1-4, 11-18<br>5-10 |
| X<br>A | JP 2015-017231 A (TOPPAN PRINTING CO., LTD.) 29 January 2015, paragraphs [0017]-[0032], [0047]-[0051], [0079]-[0080], [0099] (Family: none) | 1, 3-4, 11-18<br>2, 5-10 |
| A | JP 2014-133740 A (CAMBRIDGE DISPLAY TECHNOLOGY LIMITED) 24 July 2014, paragraphs [0132]-[0134], [0149]-[0150] & US 2014/0193937 A1, paragraphs [0122]-[0123], [0144]-[0145] & GB 2509718 A & EP 2755255 A1 & CN 103915579 A & KR 10-2014-0090577 A & TW 201431829 A | 10 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2006279007 A
- JP 2013181103 A
- JP 2017065665 A
- JP 2017065667 A
- JP 2017119632 A
- WO 2010140553 A
- JP 2000036390 A
- JP 2005075948 A
- JP 2003213002 A


### Non-patent literature cited in the description


- *Adv. Mater.,* 2009, vol. 21, 4802-4906
- *Appl. Phys. Lett.,* 2011, vol. 98, 083302
- *Chem. Comm.,* 2012, vol. 48, 9580
- *Appl. Phys. Lett.,* 2012, vol. 101, 093306
- *J. Am. Chem. Soc.,* 2012, vol. 134, 14706
- *Chem. Comm.,* 2012, vol. 48, 11392
- *Nature,* 2012, vol. 492, 234
- *Adv. Mater.,* 2013, vol. 25, 3319
- *J. Phys. Chem. A,* 2013, vol. 117, 5607
- *Phys. Chem. Chem. Phys.,* 2013, vol. 15, 15850
- *Chem. Comm.,* 2013, vol. 49, 10385
- *Chem. Lett.,* 2014, vol. 43, 319